# EUROPEAN PATENT APPLICATION

(11) **EP 1 674 874 A1**
(43) Date of publication of application: **28.06.2006**
(21) Application number: 04788191.7
(22) Date of filing: 27.09.2004
(51) Int. Cl.: G01R 31/02

(54) **CIRCUIT BOARD INSPECTION DEVICE**

(30) Priority: 14.10.2003 JP 2003353879
(71) Applicant: JSR Corporation, Tokyo 104-0045 (JP)
(72) Inventor: KIMURA, Kiyoshi, c/o JSR Microtech Inc., Saitama 3501236 (JP); SHIMODA, Sugiro, c/o JSR Microtech Inc., Saitama 3501236 (JP)
(74) Representative: TBK-Patent
(86) International application number: PCT/JP2004/014095
(87) International publication number: WO 2005/036188

(57) **Abstract**

Disclosed herein are an inspection apparatus for circuit board and an inspection process for circuit board, by which an anisotropically conductive elastomer sheet is prevented from causing trouble prematurely, long service life is achieved, stable electrical connection is attained to all electrodes to be inspected, and inspection can be conducted with high reliability even when a circuit board has projected electrodes to be inspected arranged at a small pitch, and the projected height of the electrodes to be inspected varies, and a wiring board for connection used in the inspection apparatus for circuit board.

The inspection apparatus for circuit board of the invention is an inspection apparatus for circuit board for inspecting a circuit board having a plurality of electrodes to be inspected arranged in lattice, which comprises an adaptor having a wiring board for connection, on the front surface of which a plurality of connecting electrodes have been formed corresponding to the electrodes to be inspected, and an anisotropically conductive elastomer sheet arranged on the front surface of the wiring board for connection, and a pressing pin mechanism arranged on the back surface side of the wiring board for connection and having a great number of pressing pins, wherein the pressing pins are arranged in such a manner that at least one pressing pin is located within a rectangular region partitioned by linking central points of adjacent 4 connecting electrodes when the pressing pin mechanism and the adaptor are seen through in a thickness-wise direction thereof.

## Description

### TECHNICAL FIELD

The present invention relates to an inspection apparatus and an inspection process for circuit board for inspecting the electrical properties of a circuit board for making up or mounting electronic parts such as integrated circuit devices, and a wiring board for connection, which can be suitably used in this inspection apparatus for circuit board.

### BACKGROUND ART

With respect to a circuit board for making up or mounting electronic parts, such as packaged LSI such as BGA and CSP, MCM, and other integrated circuit devices, it is necessary to inspect the electrical properties of the circuit board before the electronic parts or the like are assembled or mounted for the purpose of confirming that a wiring pattern of the circuit board has the expected performance.

As an inspection apparatus for inspecting the electrical properties of a circuit board, there has heretofore been known that comprising an inspection electrode device, in which a great number of inspection electrodes electrically connected to a tester are arranged, and an adaptor for electrically connecting the inspection electrodes of this inspection electrode device to electrodes to be inspected of a circuit board that is an object of inspection. As the adaptor of such an inspection apparatus, there has been known that having a wiring board for connection composed of a printed wiring board and an anisotropically conductive elastomer sheet arranged on the surface of this wiring board for connection.

As the wiring board for connection in this adaptor, are known that having, on a front surface thereof, a plurality of connecting electrodes arranged in accordance with a pattern corresponding to a pattern of electrodes to be inspected of a circuit board, which is an object of inspection, and, on a back surface thereof, a plurality of terminal electrodes arranged in accordance with a pattern corresponding to a pattern of inspection electrodes of an inspection electrode device (see, for example, Patent Literature 1), that having, on a front surface thereof, pairs of connecting electrodes each composed of a connecting electrode for current supply and a connecting electrode for voltage measurement and arranged in accordance with a pattern corresponding to electrodes to be inspected of a circuit board, which is an object of inspection, and, on a back surface thereof, a plurality of terminal electrodes arranged in accordance with a pattern corresponding to a pattern of inspection electrodes of an inspection electrode device (see, for example, Patent Literature 2), and the like. The adaptor having the former wiring board for connection is used in, for example, an open short-circuit test of each circuit in a circuit board, and the adaptor having the latter wiring board is used in an electric resistance-measuring test of each circuit in a circuit board.

The anisotropically conductive elastomer sheet is a sheet exhibiting conductivity only in its thickness-wise direction or exhibiting conductivity only in the thickness-wise direction when it is pressurized, and those of various structures have heretofore been known. For example, Patent Literature 3 or the like discloses an anisotropically conductive sheet (hereinafter also referred to as "dispersion type anisotropically conductive sheet") obtained by uniformly dispersing metal particles in an elastomer, and Patent Literature 4 or the like discloses an anisotropically conductive elastomer sheet (hereinafter also referred to as "uneven distribution type anisotropically conductive sheet") obtained by unevenly distributing particles of a conductive magnetic substance in an elastomer to form a great number of conductive path-forming parts each extending in a thickness-wise direction thereof and an insulating part mutually insulating them. Further, Patent Literature 5 or the like discloses an uneven distribution type anisotropically conductive sheet with a difference in level defined between the surface of each conductive path-forming part and an insulating part.

These anisotropically conductive elastomer sheets are obtained by charging a molding material with conductive particles exhibiting magnetism contained in a material for polymeric substance, which will become an elastic polymeric substance by being cured, into a mold, thereby forming a molding material layer having a necessary thickness, applying a magnetic field to the molding material layer in a thickness-wise direction thereof and subjecting the molding material layer to a curing treatment. In such an anisotropically conductive elastomer sheet, the conductive particles are contained in the base material composed of the elastic polymeric substance in a state oriented so as to align in the thickness-wise direction, and a conductive path is formed by a chain of a great number of the conductive particles.

Among such anisotropically conductive elastomer sheets, the dispersion type anisotropically conductive sheet has the advantage of the following points compared with the uneven distribution type anisotropically conductive sheet.
(1) The uneven distribution type anisotropically conductive sheet needs to be produced by using a special and expensive mold, whereas the dispersion type anisotropically conductive sheet can be produced at low cost without using such a mold.
(2) The uneven distribution type anisotropically conductive sheet needs to form conductive path-forming parts in accordance with a pattern corresponding to a pattern of, for example, electrodes to be inspected and is individually produced according to a circuit board that is an object of inspection, whereas the dispersion type anisotropically conductive sheet can be used irrespective of the pattern of electrodes to be inspected and thus has general-purpose property.
(3) Since the uneven distribution type anisotropically conductive sheet exhibits conductivity in its conductive path-forming parts in the thickness-wise direction thereof and does not exhibit conductivity in its insulating part, positioning of the conductive path-forming parts to electrodes to be inspected is required when the uneven distribution type anisotropically conductive sheet is used, whereas the dispersion type anisotropically conductive sheet exhibits conductivity over the whole surface thereof in the thickness-wise direction thereof, and so positioning of the conductive path-forming parts to the electrodes to be inspected is unnecessary, and an electrically connecting operation becomes easy.

On the other hand, in the uneven distribution type anisotropically conductive sheet, the insulating part mutually insulating adjacent conductive path-forming parts is formed between the adjacent conductive path-forming parts, so that the uneven distribution type anisotropically conductive sheet has the advantage of having performance that electrical connection to respective electrodes to be inspected can be achieved with high reliability in a state that necessary insulating property has been retained between adjacent electrodes to be inspected even about a circuit board, in which the electrodes to be inspected are arranged at a small pitch, i.e., high resolving power compared with the dispersion type anisotropically conductive sheet.

In the dispersion type anisotropically conductive sheet, however, higher resolving power is achieved as its thickness becomes small because conductive paths formed in the thickness-wise direction become short. Accordingly, that having a small thickness is used as the dispersion type anisotropically conductive sheet in the adaptor when a circuit board, in which a pitch between electrodes to be inspected is small, is inspected.

In an inspection apparatus for circuit board having such an adaptor, the adaptor is pressed by, for example, the inspection electrode device, whereby the anisotropically conductive elastomer sheet in the adaptor is brought into contact under pressure with a circuit board, which is an object of inspection, thereby forming conductive paths in the anisotropically conductive elastomer sheet in the thickness-wise direction thereof. As a result, electrical connection of electrodes to be inspected in the circuit board to the connecting electrodes in the wiring board for connection is achieved to bring about an inspectable state. In this inspectable state, necessary electrical inspection as to the circuit board is conducted.

In electronic parts such as packaged LSI for surface mounting, such as BGA and CSP, as methods for mounting semiconductor chips on a circuit board for making up such an electronic part, are known a wire bonding method, a TAB method, a flip chip mounting method, etc. Among these mounting methods, the flip chip mounting method, in which a wiring length between a semiconductor chip and a circuit board is extremely short, is advantageous in that miniaturization of a package and speeding-up of signal transmission can be achieved.

As such flip chip mounting methods, are known a method of using, as a semiconductor chip, that, on which projected electrodes composed of solder have been formed, and melting and solidifying the projected electrodes formed on the semiconductor chip to be joined to electrodes of a circuit board, thereby achieving electrical connection between both electrodes, and a method of using, as a circuit board, that having projected electrodes composed of solder and melting and solidifying the projected electrodes formed on the circuit board to be joined to electrodes of a semiconductor chip, thereby achieving electrical connection between both electrodes.

With respect to the circuit board used in the latter flip chip mounting method, it is subjected to inspection on its electrical properties in a state that the projected electrodes have been formed.

When the electrical inspection of the circuit board having such projected electrodes to be inspected is conducted by the inspection apparatus having the adaptor described above, however, the following problems are involved.

In the electrical inspection of the circuit board having the projected electrodes to be inspected, excessive pressing force is applied to a part of the anisotropically conductive elastomer sheet in the adaptor by electrodes to be inspected of a higher projected height because the projected height of the electrodes to be inspected varies. As a result, such an anisotropically conductive elastomer sheet tends to cause trouble. In particular, when an anisotropically conductive elastomer sheet having a small thickness is used, such an anisotropically conductive elastomer sheet tends to cause trouble prematurely because its strength is small. Accordingly, the service life of the anisotropically conductive elastomer sheet becomes short.

Although the anisotropically conductive elastomer sheet having a small thickness is high in resolving power, the degree of elastic deformation in its thickness-wise direction is small and its level difference-absorbing ability is low. It is thus difficult to achieve stable electrical connection to a circuit board having electrodes to be inspected whose projected height varies.
Patent Literature 1: Japanese Patent Application Laid-Open No. 249924/1994;
Patent Literature 2: Japanese Patent Application Laid-Open No. 2001-235492;
Patent Literature 3: Japanese Patent Application Laid-Open No. 93393/1976;
Patent Literature 4: Japanese Patent Application Laid-Open No. 147772/1978;
Patent Literature 5: Japanese Patent Application Laid-Open No. 250906/1986.

### DISCLOSURE OF THE INVENTION

The present invention has been made on the basis of the foregoing circumstances and has as its first object the provision of an inspection apparatus for circuit board having an anisotropically conductive elastomer sheet, by which the anisotropically conductive elastomer sheet is prevented from causing trouble prematurely, long service life is achieved, stable electrical connection is attained to all electrodes to be inspected, and inspection can be carried out with high reliability even when a circuit board, which is an object of inspection, has projected electrodes to be inspected arranged at a small pitch, and the projected height of the electrodes to be inspected varies.

A second object of the present invention is to provide an inspection process for circuit board making use of an anisotropically conductive elastomer sheet, by which the anisotropically conductive elastomer sheet is prevented from causing trouble prematurely, long service life is achieved, stable electrical connection is attained to all electrodes to be inspected, and inspection can be carried out with high reliability even when a circuit board, which is an object of inspection, has projected electrodes to be inspected arranged at a small pitch, and the projected height of the electrodes to be inspected varies.

A third object of the present invention is to provide a wiring board for connection, which can be suitably used in the above-described inspection apparatus for circuit board.

According to the present invention, there is provided an inspection apparatus for circuit board for inspecting the electrical properties of a circuit board having a plurality of electrodes to be inspected arranged in lattice, which comprises an adaptor having a wiring board for connection, on the front surface of which a plurality of connecting electrodes have been formed in accordance with a pattern corresponding to a pattern of the electrodes to be inspected of the circuit board, which is an object of inspection, and an anisotropically conductive elastomer sheet arranged on the front surface of the wiring board for connection, and a pressing pin mechanism arranged on the back surface side of the wiring board for connection in the adaptor and having a great number of pressing pins for pressing the adaptor,
wherein the great number of the pressing pins in the pressing pin mechanism are arranged in such a manner that at least one pressing pin is located within a rectangular region partitioned by linking central points of adjacent 4 connecting electrodes in the wiring board for connection when the pressing pin mechanism and the adaptor are seen through in a thickness-wise direction thereof.

In this inspection apparatus for circuit board, it may be preferable that on the back surface of the wiring board for connection in the adaptor, a terminal electrode electrically connected to the connecting electrode be arranged at pressing positions by all the pressing pins in the pressing pin mechanism or a pressing position by at least one specified pressing pin selected from among all the pressing pins, and an inspection electrode be formed on the tip of the pressing pin pressing the pressing position at which the terminal electrode is arranged.

According to the present invention, there is also provided an inspection apparatus for circuit board for inspecting the electrical properties of a circuit board having a plurality of electrodes to be inspected arranged in lattice, which comprises an adaptor having a wiring board for connection, on the front surface of which plural pairs of connecting electrodes each composed of a connecting electrode for current supply and a connecting electrode for voltage measurement have been formed in accordance with a pattern corresponding to a pattern of the electrodes to be inspected of the circuit board, which is an object of inspection, and an anisotropically conductive elastomer sheet arranged on the front surface of the wiring board for connection, and a pressing pin mechanism arranged on the back surface side of the wiring board for connection in the adaptor and having a great number of pressing pins for pressing the adaptor, wherein the great number of the pressing pins in the pressing pin mechanism are arranged in such a manner that at least one pressing pin is located within a rectangular region partitioned by linking central points of adjacent 4 pairs of connecting electrodes in the wiring board for connection when the pressing pin mechanism and the adaptor are seen through in a thickness-wise direction thereof.

In this inspection apparatus for circuit board, it may be preferable that on the back surface of the wiring board for connection in the adaptor, terminal electrodes electrically connected to any ones of the connecting electrodes for current supply and the connecting electrodes for voltage measurement be arranged at pressing positions by all the pressing pins in the pressing pin mechanism or a pressing position by at least one specified pressing pin selected from among all the pressing pins, and inspection electrodes be formed on the tips of the pressing pins pressing the pressing positions at which the terminal electrodes are arranged.

In the inspection apparatus for circuit board according to the present invention, a particularly excellent effect may be exhibited when the circuit board, which is the object of inspection, is that having projected electrodes to be inspected.

In such a inspection apparatus for circuit board, the wiring board for connection in the adaptor may preferably be capable to be curved in such a manner that when the adaptor is held under pressure by the respective pressing pins in the pressing pin mechanism and the respective electrodes to be inspected of the circuit board, which is the object of inspection, portions being applied with the pressing force by the respective pressing pins and the respective electrodes to be inspected are shifted in pressing directions.

In the inspection apparatus for circuit board according to the present invention, it may be preferable that the anisotropically conductive elastomer sheet arranged on the front surface of the wiring board for connection be obtained by containing a great number of conductive particles exhibiting magnetism in an elastic polymeric substance, and the conductive particles be oriented so as to align in a thickness-wise direction of the sheet, thereby forming a plurality of chains by the conductive particles.

The anisotropically conductive elastomer sheet arranged on the front surface of the wiring board for connection may be such that chains by the conductive particles are formed in a state dispersed in a plane direction, and such an anisotropically conductive elastomer sheet may preferably have a thickness of 30 to 300 µm. In the inspection apparatus for circuit board according to the present invention, the adaptor may preferably have an anisotropically conductive elastomer sheet arranged on the back surface of the wiring board for connection.

According to the present invention, there is further provided an inspection process for circuit board for inspecting the electrical properties of a circuit board having a plurality of projected electrodes to be inspected arranged in lattice, which comprises
using an adaptor having a wiring board for connection and an anisotropically conductive elastomer sheet arranged on a front surface of the wiring board for connection, and a pressing pin mechanism, on which a great number of pressing pins for pressing the adaptor have been arranged, and comprises the steps of
arranging the adaptor on the circuit board, which is an object of inspection, so as to bring the anisotropically conductive elastomer sheet thereof into contact with the circuit board to attain a state that the pressing pin mechanism has been arranged in such a manner that at least one pressing pin is located within a rectangular region partitioned by linking central points of adjacent 4 electrodes to be inspected in the circuit board when the adaptor and the circuit board are seen through in a thickness-wise direction thereof, and
pressing the adaptor by the respective pressing pins of the pressing pin mechanism to bring the anisotropically conductive elastomer sheet in the adaptor into contact under pressure with the electrodes to be inspected of the circuit board, thereby attaining an inspectable state that each of the electrodes to be inspected of the circuit board have been electrically connected to a tester,
wherein the wiring board for connection in the adaptor is capable to be curved in such a manner that portions being applied with the pressing force by the respective pressing pins and the respective electrodes to be inspected are shifted in the pressing direction.

According to the present invention, there is still further provided a wiring board for connection for intervening between a circuit board having a plurality of electrodes to be inspected arranged in lattice and a tester to inspect the electrical properties of the circuit board, which comprises
a plurality of connecting electrodes formed in accordance with a pattern corresponding to a pattern of the electrodes to be inspected of the circuit board, which is an object of inspection, on a front surface thereof and a plurality of terminal electrodes electrically connected to the connecting electrodes on a back surface thereof,
wherein the plurality of the terminal electrodes are arranged in such a manner that at least one terminal electrode is located within a rectangular region partitioned by linking central points of adjacent 4 connecting electrodes when the wiring board for connection is seen through in a thickness-wise direction thereof.

According to the present invention, there is yet still further provided a wiring board for connection for intervening between a circuit board having a plurality of electrodes to be inspected arranged in lattice and a tester to inspect the electrical properties of the circuit board, which comprises
plural pairs of connecting electrodes each composed of a connecting electrode for current supply and a connecting electrode for voltage measurement and formed in accordance with a pattern corresponding to a pattern of the electrodes to be inspected of the circuit board, which is an object of inspection, on a front surface thereof and a plurality of terminal electrodes electrically connected to any ones of the connecting electrodes for current supply and the connecting electrodes for voltage measurement on a back surface thereof,
wherein the plurality of the terminal electrodes are arranged in such a manner that at least one terminal electrode is located within a rectangular region partitioned by linking central points of adjacent 4 pairs of connecting electrodes when the wiring board for connection is seen through in a thickness-wise direction thereof.
In the present invention, the term "pressing pin is located within a rectangular region" means that the tip surface (pressing surface) of the pressing pin is located within this rectangular region in a state not extending over within other rectangular regions.
The term "pressing an adaptor" means both cases where the pressing pins are moved in a direction approaching the adaptor, thereby pressing the adaptor by the pressing pins and where the adaptor is moved in a direction approaching the pressing pins, thereby bringing the tip surfaces of the pressing pins into contact under pressure with the adaptor, and consequently pressing the adaptor by the pressing pins.
In the present invention, in an inspectable state that the adaptor is pressed by the respective pressing pins of the pressing pin mechanism to bring the anisotropically conductive elastomer sheet in the adaptor into contact under pressure with the electrodes to be inspected in the circuit board, which is the object of inspection, whereby the respective electrodes to be inspected of the circuit board are electrically connected to a tester, at least one pressing pin is located within a rectangular region partitioned by linking central points of adjacent 4 electrodes to be inspected in the circuit board when the adaptor and the circuit board are seen through in a thickness-wise direction thereof. As a result, the wiring board for connection in the adaptor is curved in such a manner that portions being applied with the pressing force by the respective pressing pins and the respective electrodes to be inspected are shifted in pressing directions. In other words, the wiring board for connection is forcedly deformed in the form of a wave to function as the so-called plate spring. As a result, the pressing force applied to the anisotropically conductive elastomer sheet is relaxed by virtue of the spring elasticity of the wiring board for connection even when the projected height of the electrodes to be inspected varies, whereby excessive pressing force is applied to a part of the anisotropically conductive elastomer sheet.

According to the present invention, the anisotropically conductive elastomer sheet is thus prevented from causing trouble prematurely, and originally designed long service life that the anisotropically conductive elastomer sheet to have can be obtained even when the projected height of the electrodes to be inspected in the circuit board, which is the object of inspection, varies, and the thickness of the anisotropically conductive elastomer sheet used is small.

In the present invention, the wiring board for connection is deformed according to the projected height of each electrode to be inspected in the inspectable state even when the projected height of the electrodes to be inspected in the circuit board, which is the object of inspection, varies, so that the scatter of the projected height in the electrodes to be inspected is sufficiently absorbed even when that having a small thickness is used as the anisotropically conductive elastomer sheet.

According to the present invention, stable electrical connection is thus attained to all electrodes to be inspected, and inspection can be carried out with high reliability even when a circuit board, which is an object of inspection, has projected electrodes to be inspected arranged at a small pitch, and the projected height of the electrodes to be inspected varies.

### BRIEF DESCRIPTION OF THE DRAWINGS

Fig. 1 illustrates the construction of an inspection apparatus for circuit board according to a first embodiment of the present invention together with a circuit board that is an object of inspection.
Fig. 2 illustrates, on an enlarged scale, a principal part of an upper-side jig for inspection in the inspection apparatus for circuit board according to the first embodiment.
Fig. 3 illustrates, on an enlarged scale, a principal part of a lower-side jig for inspection in the inspection apparatus for circuit board according to the first embodiment.
Fig. 4 is a cross-sectional view illustrating the construction of a first anisotropically conductive elastomer sheet in an upper-side adaptor.
Fig. 5 illustrates a positional relation among connecting electrodes, terminal electrodes and pressing pins when an upper-side pressing pin mechanism and the upper-side adaptor in the inspection apparatus for circuit board according to the first embodiment are seen through in a thickness-wise direction thereof.
Fig. 6 illustrates a positional relation between electrodes to be inspected and pressing pins when the upper-side pressing pin mechanism, the upper-side adaptor and the circuit board to be inspected in an inspectable state in the inspection apparatus for circuit board according to the first embodiment are seen through in a thickness-wise direction thereof.
Fig. 7 is a cross-sectional view illustrating a deformed state of the upper-side adaptor in the inspectable state in the inspection apparatus for circuit board according to the first embodiment.
Fig. 8 illustrates the construction of an inspection apparatus for circuit board according to a second embodiment of the present invention together with a circuit board that is an object of inspection.
Fig. 9 illustrates, on an enlarged scale, a principal part of an upper-side jig for inspection in the inspection apparatus for circuit board according to the second embodiment.
Fig. 10 illustrates, on an enlarged scale, a principal part of a lower-side jig for inspection in the inspection apparatus for circuit board according to the second embodiment.
Fig. 11 illustrates a positional relation among pairs of connecting electrodes, terminal electrodes and pressing pins when an upper-side pressing pin mechanism and an upper-side adaptor in the inspection apparatus for circuit board according to the second embodiment are seen through in a thickness-wise direction thereof.
Fig. 12 illustrates a positional relation between electrodes to be inspected and pressing pins when the upper-side pressing pin mechanism, the upper-side adaptor and the circuit board to be inspected in an inspectable state in the inspection apparatus for circuit board according to the second embodiment are seen through in a thickness-wise direction thereof.
Fig. 13 illustrates a positional relation among connecting electrodes, terminal electrodes and pressing pins when an upper-side pressing pin mechanism and an upper-side adaptor in a modified inspection apparatus for circuit board according to an embodiment of the present invention are seen through in a thickness-wise direction thereof.
Fig. 14 illustrates a positional relation among connecting electrodes, terminal electrodes and pressing pins when an upper-side pressing pin mechanism and an
   upper-side adaptor in an inspection apparatus for circuit board according to Comparative Example 1 are seen through in a thickness-wise direction thereof.
Fig. 15 illustrates a positional relation among pairs of connecting electrodes, terminal electrodes and pressing pins when an upper-side pressing pin mechanism and an upper-side adaptor in an inspection apparatus for circuit board according to Comparative Example 2 are seen through in a thickness-wise direction thereof.

### DESCRIPTION OF CHARACTERS

- 1: Circuit board to be inspected
- 2: One surface-side electrodes to be inspected,
- 3: Other surface-side electrodes to be inspected,
- 10: Upper-side jig for inspection,
- 20: Upper-side adaptor,
- 21: Wiring board for connection,
- 22: Connecting electrodes,
- 22a: Connecting electrodes for current supply,
- 22b: Connecting electrodes for voltage measurement,
- 22c: Pair of connecting electrodes,
- 23: Terminal electrodes,
- 25: First anisotropically conductive elastomer sheet,
- 25A: Base material,
- 26: Second anisotropically conductive elastomer sheet,
- 30: Upper-side pressing pin mechanism,
- 31,: 31A, 31B Pressing pins,
- 32: Body part,
- 33: Projected part,
- 34: Flange part,
- 35: Pressing pin supporting member,
- 36: Proximal-side supporting plate,
- 36H: Through-hole,
- 37: Tip-side supporting plate,
- 37A: Recess,
- 37H: Through-hole,
- 40: Lower-side jig for inspection,
- 50: Lower-side adaptor,
- 51: Wiring board for connection,
- 52: Connecting electrodes,
- 52a: Connecting electrodes for current supply,
- 52b: Connecting electrodes for voltage measurement,
- 52c: Pair of connecting electrodes,
- 53: Terminal electrodes,
- 55: First anisotropically conductive elastomer sheet,
- 56: Second anisotropically conductive elastomer sheet,
- 60: Lower-side pressing pin mechanism,
- 61: Pressing pins,
- 62: Body part,
- 63: Projected part,
- 64: Flange part,
- 65: Pressing pin supporting member,
- 66: Proximal-side supporting plate,
- 66H: Through-hole,
- 67: Tip-side supporting plate,
- 67A: Recess,
- 67H: Through-hole,
- P: Conductive particles,
- W: Electric wire.

### BEST MODE FOR CARRYING OUT THE INVENTION

The mode for carrying out the present invention will hereinafter be described.

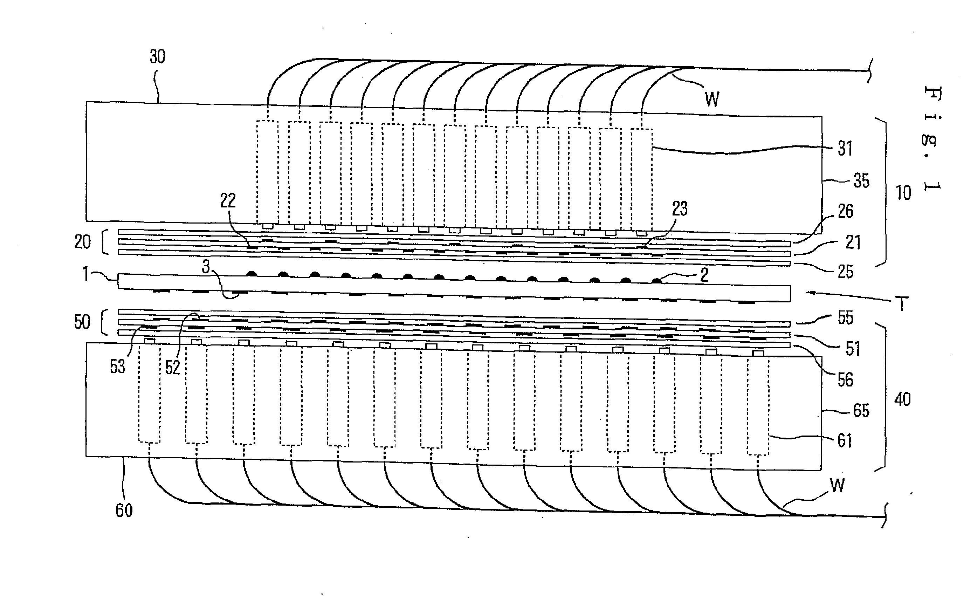

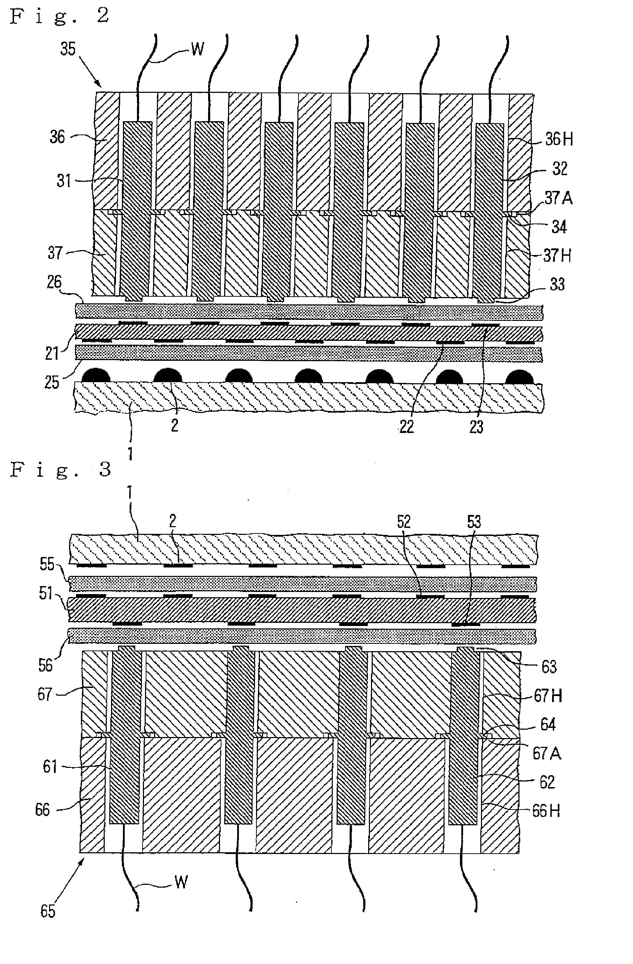

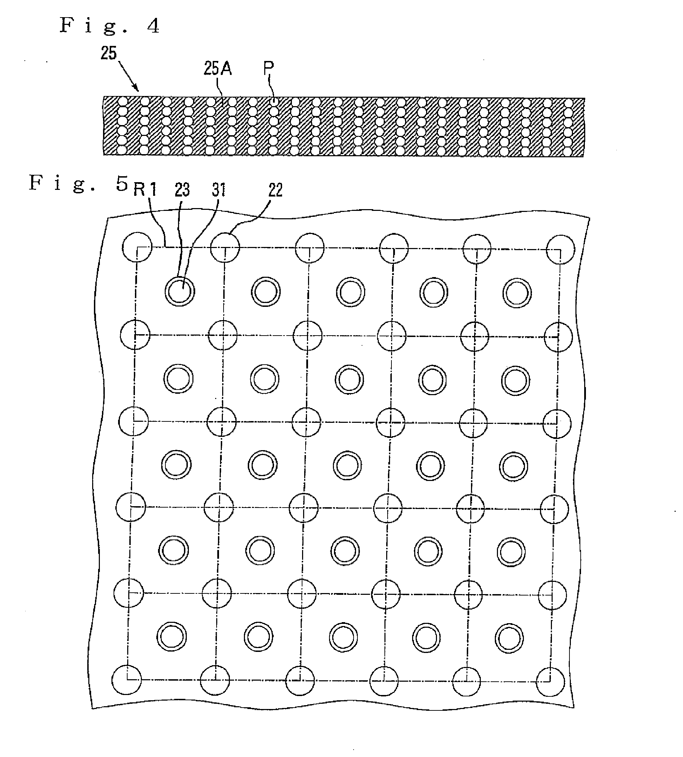

Fig. 1 illustrates the construction of an inspection apparatus for circuit board according to a first embodiment of the present invention together with a circuit board that is an object of inspection, Fig. 2 illustrates, on an enlarged scale, a principal part of an upper-side jig for inspection in the inspection apparatus for circuit board shown in Fig. 1, and Fig. 3 illustrates, on an enlarged scale, a principal part of a lower-side jig for inspection in the inspection apparatus for circuit board shown in Fig. 1. This inspection apparatus for circuit board is used for carrying out, for example, an open short-circuit test on a circuit board (hereinafter also referred to as "circuit board to be inspected") 1 that is an object of inspection.

The circuit board 1 to be inspected used in this inspection apparatus for circuit board is a circuit board for making up, for example, a packaged LSI such as BGA and having, on one surface (upper surface in Fig. 1) thereof, a plurality of projected one surface-side electrodes 2 to be inspected arranged in lattice and, on the other surface (lower surface in Fig. 1) thereof, a plurality of flat plate-like other surface-side electrodes 3 to be inspected arranged according to positions of lattice points. A semiconductor chip is mounted on the one surface thereof by the flip chip mounting method, and solder ball electrodes are formed on the other surface-side electrodes 3 to be inspected to form BGA.

In this inspection apparatus for circuit board, an upper-side jig 10 for inspection is provided above an inspection-executing region T in which the circuit board 1 to be inspected is horizontally arranged. On the other hand, a lower-side jig 40 for inspection is provided below the inspection-executing region T. The upper-side jig 10 for inspection and lower-side jig 40 for inspection are supported by proper supporting mechanisms (not illustrated), whereby the upper-side jig 10 for inspection and lower-side jig 40 for inspection are arranged so as to oppose to each other in a vertical direction.

The upper-side jig 10 for inspection is composed of an upper-side adaptor 20 having a wiring board 21 for connection and an upper-side pressing pin mechanism 30 arranged on a back surface side (upper surface side in Figs. 1 and 2) of the wiring board 21 for connection in the upper-side adaptor 20.

The upper-side adaptor 20 is composed of the wiring board 21 for connection, a first anisotropically conductive elastomer sheet 25 arranged on a front surface (lower surface in Figs. 1 and 2) of the wiring board 21 for connection and a second anisotropically conductive elastomer sheet 26 arranged on a back surface of the wiring board 21 for connection and is provided shiftably in a direction (vertical direction) separating from and coming close to the upper-side pressing pin mechanism 30.

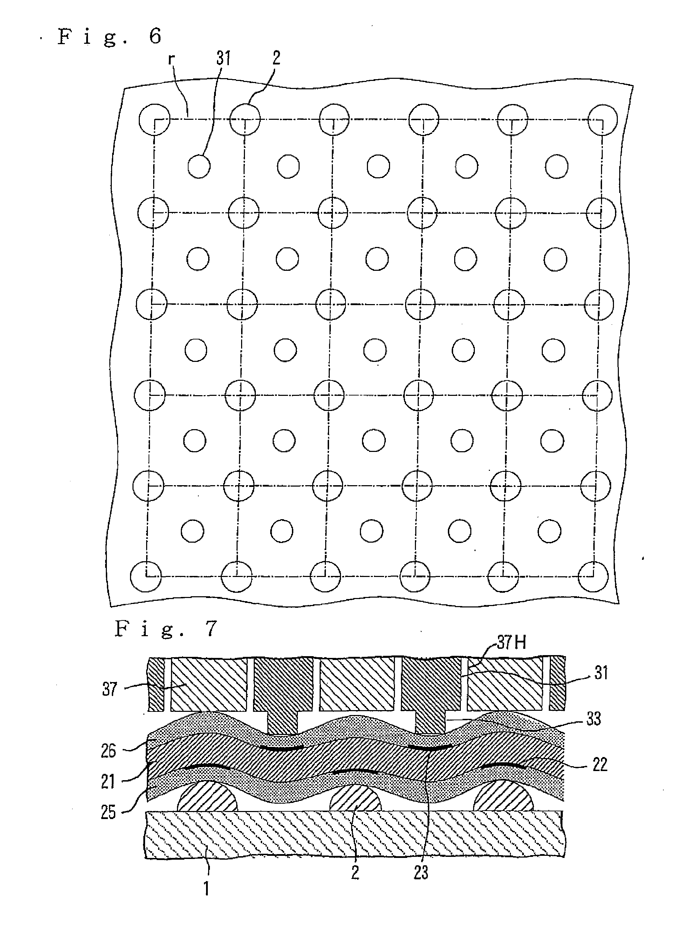

On the front surface of the wiring board 21 for connection, a plurality of connecting electrodes 22 are formed in accordance with a pattern corresponding to a pattern of the one surface-side electrodes 2 to be inspected of the circuit board 1 to be inspected. On the back surface of the wiring board 21 for connection, terminal electrodes 23 are formed at respective pressing positions by pressing pins 31 in the upper-side pressing pin mechanism 30, which will be described subsequently. More specifically, the terminal electrodes 23 are formed in accordance with a pattern corresponding to an arrangement pattern of the pressing pins 31 in the upper-side pressing pin mechanism 30, one terminal electrode 23 is located at a central position in a rectangular region partitioned by linking central points of adjacent 4 connecting electrodes 22 in the wiring board 21 for connection when the wiring board 21 for connection is seen through in a thickness-wise direction thereof, and the terminal electrode 23 is arranged so as not to overlap the connecting electrode 22 (see Fig. 5). Each of the connecting electrodes 22 is electrically connected to a suitable terminal electrode 23 through an internal wiring (not illustrated).

In the embodiment illustrated, the connecting electrodes 22 are electrically connected to the terminal electrodes 23 in relation of one to one. More specifically, one connecting electrode 22 is electrically connected to one terminal electrode 23. In an actual construction, however, the electrical connection between both electrodes may be achieved according to the wiring pattern of the circuit board 1 to be inspected and the purpose of inspection. Accordingly, all the connecting electrodes 22 and the terminal electrodes 23 do not always need to be electrically connected to each other in relation of one to one. For example, a plurality of connecting electrodes 22 may be electrically connected to a terminal electrode 23 through a common internal wiring.

As a base material for forming the wiring board 21 for connection, may be use that generally used as a base material for printed wiring boards. As specific preferable examples thereof, may be mentioned polyimide resins, glass fiber-reinforced polyimide resins, glass fiber-reinforced epoxy resins and glass fiber-reinforced bismaleimidotriazine resins.

The wiring board 21 for connection preferably has flexibility to the extent that it is curved in such a manner that when the adaptor 20 is held under pressure by the respective pressing pins 31 in the pressing pin mechanism 30, which will be described subsequently, and the respective one surface-side electrodes 2 to be inspected of the circuit board 1 to be inspected, portions being applied with the pressing force by the respective pressing pins 31 and the respective electrodes 2 to be inspected are shifted in pressing directions.

The degree of specific flexibility required of the wiring board 21 for connection is suitably set in view of the diameter, pitch and the like of the one surface-side electrodes 2 to be inspected of the electrode 1 to be inspected.

The thickness of the wiring board 21 for connection is suitably selected according to the material of the wiring board 21 for connection and the degrees of strength and flexibility required of it. When a glass fiber-reinforced resin material is used as the material of the wiring board 21 for connection, the thickness is preferably 30 to 300 µm, more preferably 50 to 200 µm.

In the first anisotropically conductive elastomer sheet 25, a great number of conductive particles P exhibiting magnetism are contained in a base material 25A composed of an elastic polymeric substance, and these conductive particles P are oriented so as to align in a thickness-wise direction of the sheet, thereby forming a plurality of chains by the conductive particles as illustrated in Fig. 4. The first anisotropically conductive elastomer sheet 25 according to the embodiment illustrated is such that the chains by the conductive particles are formed in a state dispersed in a plane direction.

In such a first anisotropically conductive elastomer sheet 25, the thickness is preferably 20 to 250 µm, more preferably 50 to 200 µm. If this thickness is too small, the degree of elastic deformation of such an anisotropically conductive elastomer sheet in its thickness-wise direction becomes small, and its stress-absorbing ability tends to lower, and so the circuit board 1 to be inspected is liable to be damaged. In addition, it may be difficult in some cases to achieve stable electrical connection to the circuit board 1 to be inspected. If this thickness exceeds 500 µm on the other hand, such an anisotropically conductive elastomer sheet tends to have a high electric resistance in the thickness-wise direction. In addition, it may be difficult in some cases to obtain high resolving power.

The elastic polymeric substance forming the base material 25A in the first anisotropically conductive elastomer sheet 25 is preferably a polymeric substance having a crosslinked structure. As curable polymeric substance-forming materials usable for obtaining a crosslinked polymeric substance, may be used various materials. Specific examples thereof include conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene-diene block terpolymer rubber and styreneisoprene block copolymers, and hydrogenated products thereof; and besides chloroprene rubber, urethane rubber, polyester rubber, epichlorohydrin rubber, silicone rubber, ethylene-propylene copolymer rubber and ethylene-propylenediene terpolymer rubber.

When weather resistance is required of the resulting anisotropically conductive elastomer sheet in the embodiment described above, any other material than conjugated diene rubbers is preferably used. In particular, silicone rubber is preferably used from the viewpoints of molding or forming and processing ability and electrical properties.

As the silicone rubber, is preferred that obtained by crosslinking or condensing liquid silicone rubber. The liquid silicone rubber preferably has a viscosity not higher than 10⁵ poises as measured at a shear rate of 10⁻¹ sec and may be any of condensation type, addition type and those having a vinyl group or hydroxyl group. As specific examples thereof, may be mentioned dimethyl silicone raw rubber, methylvinyl silicone raw rubber and methylphenylvinyl silicone raw rubber.

Among these, vinyl group-containing liquid silicone rubber (vinyl group-containing dimethyl polysiloxane) is generally obtained by subjecting dimethyldichlorosilane or dimethyldialkoxysilane to hydrolysis and condensation reaction in the presence of dimethylvinylchlorosilane or dimethylvinylalkoxysilane and successively fractionating the reaction product by, for example, repeated dissolution-precipitation.

Liquid silicone rubber having vinyl groups at both terminals thereof is obtained by subjecting a cyclic siloxane such as octamethylcyclotetrasiloxane to anionic polymerization in the presence of a catalyst, using, for example, dimethyldivinylsiloxane as a polymerization terminator and suitably selecting other reaction conditions (for example, amounts of the cyclic siloxane and polymerization terminator). As the catalyst for the anionic polymerization, may be used an alkali such as tetramethylammonium hydroxide or n-butylphosphonium hydroxide or a silanolate solution thereof. The reaction is conducted at a temperature of, for example, 80 to 130°C.

On the other hand, hydroxyl group-containing liquid silicone rubber (hydroxyl group-containing dimethyl polysiloxane) is generally obtained by subjecting dimethyldichlorosilane or dimethyldialkoxysilane to hydrolysis and condensation reaction in the presence of dimethylhydrochlorosilane or dimethylhydroalkoxysilane and successively fractionating the reaction product by, for example, repeated dissolution-precipitation.

The hydroxyl group-containing liquid silicone rubber is also obtained by subjecting a cyclic siloxane to anionic polymerization in the presence of a catalyst, using, for example, dimethylhydrochlorosiloxane, methyldihydrochlorosilane or dimethylhydroalkoxysilane as a polymerization terminator and suitably selecting other reaction conditions (for example, amounts of the cyclic siloxane and polymerization terminator). As the catalyst for the anionic polymerization, may be used an alkali such as tetramethylammonium hydroxide or n-butylphosphonium hydroxide or a silanolate solution thereof. The reaction is conducted at a temperature of, for example, 80 to 130°C.

As the liquid silicone rubber, is preferably used that having a compression set of at most 35%, more preferably at most 20% as measured in the form of a cured product at 150°C. When this compression set is at most 35%, the resulting anisotropically conductive elastomer sheet comes to have good durability when it is compressed repeatedly in its thickness-wise direction. It is hence preferable to have such a compression set.

As the liquid silicone rubber, is preferably used that having tear strength of at least 7 kN/m, more preferably at least 10 kN/m as measured in the form of a cured product at 23°C. When this tear strength is at least 7 kN/m, the resulting anisotropically conductive elastomer sheet comes to have good durability when it is compressed repeatedly in its thickness-wise direction. It is hence preferable to have such tear strength.

In the present invention, the compression set and tear strength of the cured product of the liquid silicone rubber can be measured by methods in accordance with JIS K 6249.

Such an elastic polymeric substance preferably has a molecular weight Mw (weight average molecular weight as determined in terms of standard polystyrene equivalent) of 10,000 to 40,000. It also preferably has a molecular weight distribution index (a ratio Mw/Mn of weight average molecular weight Mw as determined in terms of standard polystyrene equivalent to number average molecular weight Mn as determined in terms of standard polystyrene equivalent) of at most 2 from the viewpoint of heat resistance of the resulting anisotropically conductive elastomer sheet.

In the above, a curing catalyst for curing the polymeric substance-forming material may be contained in the polymeric substance-forming material. As such a curing catalyst, may be used an organic peroxide, fatty acid azo compound, hydrosilylated catalyst or the like.

Specific examples of the organic peroxide used as the curing catalyst include benzoyl peroxide, bisdicyclobenzoyl peroxide, dicumyl peroxide and di-tert-butyl peroxide.

Specific examples of the fatty acid azo compound used as the curing catalyst include azobisisobutyronitrile.

Specific examples of that used as the catalyst for hydrosilylation reaction include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphite and platinum, acetyl acetate platinum chelates, and cyclic diene-platinum complexes.

The amount of the curing catalyst used is suitably selected in view of the kind of the polymeric substance-forming material, the kind of the curing catalyst and other curing treatment conditions. However, it is generally 3 to 15 parts by weight per 100 parts by weight of the polymeric substance-forming material.

In the elastic polymeric substance, as needed, may be contained an inorganic filler such as general silica powder, colloidal silica, aerogel silica or alumina. By containing such an inorganic filler, the thixotropic property of the resulting molding material for obtaining the anisotropically conductive elastomer sheet is ensured, the viscosity thereof becomes high, the dispersion stability of the conductive particles is improved, and moreover the strength of the resulting anisotropically conductive elastomer sheet can be made high.

No particular limitation is imposed on the amount of such an inorganic filler used. However, the use in a too great amount is not preferred because the orientation of the conductive particles by a magnetic field cannot be sufficiently achieved.

The viscosity of the sheet-forming material is preferably within a range of 100,000 to 1,000,000 cp at a temperature of 25°C.

As the conductive particles P contained in the base material 25A, conductive particles exhibiting magnetism are preferably used from the viewpoint of permitting them to be easily oriented so as to align in a thickness-wise direction of the sheet by applying a magnetic field. Specific examples of such conductive particles P include particles of metals exhibiting magnetism, such as nickel, iron and cobalt and particles of alloys thereof, particles containing such a metal, particles obtained by using these particles as core particles and plating surfaces of the core particles with a metal having good conductivity, such as gold, silver, palladium or rhodium, particles obtained by using particles of a non-magnetic metal, particles of an inorganic substance, such as glass beads, or particles of a polymer as core particles and plating surfaces of the core particles with a conductive magnetic substance such as nickel or cobalt, and particles obtained by coating the core particles with both conductive magnetic substance and metal having good conductivity.

Among these, particles obtained by using particles composed of a ferromagnetic substance, for example, nickel particles as core particles and plating their surfaces with a metal having good conductivity, particularly gold are preferably used.

No particular limitation is imposed on a means for coating the surfaces of the core particles with the conductive metal. However, the coating may be conducted by, for example, chemical plating or electroplating.

When those obtained by coating the surfaces of the core particles with the conductive metal are used as the conductive particles P, the coating rate (proportion of an area coated with the conductive metal to the surface area of the core particles) of the conductive metal on the particle surfaces is preferably at least 40%, more preferably at least 45%, particularly preferably 47 to 95% from the viewpoint of achieving good conductivity.

The amount of the conductive metal to coat is preferably 0.5 to 50 % by weight, more preferably 1 to 30 % by weight, still more preferably 3 to 25 % by weight, particularly preferably 4 to 20 % by weight based on the core particles. When the conductive metal to coat is gold, the coating amount thereof is preferably 2 to 30 % by weight, more preferably 3 to 20 % by weight, still more preferably 3.5 to 17% by weight based on the core particles.

The number average particle diameter of the conductive particles P is preferably 1 to 200 µm, more preferably 5 to 50 µm, particularly preferably 8 to 30 µm. If this number average particle diameter is too small, it may be difficult in some cases to obtain an anisotropically conductive elastomer sheet having a low electric resistance value. If this number average particle diameter is too great on the other hand, it may be difficult in some cases to obtain an anisotropically conductive elastomer sheet having high resolving power.

No particular limitation is imposed on the form of the conductive particles P. However, they are preferably in the form of a sphere or star, or a mass of secondary particles obtained by aggregating these particles from the viewpoint of permitting them to be easily dispersed in the polymeric substance-forming material.

The water content in the conductive particles P is preferably at most 5%, more preferably at most 3%, still more preferably at most 2%, particularly preferably at most 1%. The use of conductive particles satisfying such conditions prevents or inhibits occurrence of bubbles upon a curing treatment of the polymeric substance-forming material.

Those obtained by treating surfaces of the conductive particles with a coupling agent such as a silane coupling agent may be suitably used as the conductive particles P. By treating the surfaces of the conductive particles with the coupling agent, the adhesion property of the conductive particles to the elastic polymeric substance is improved, so that the anisotropically conductive elastomer sheet is provided with high durability in repeated use.

The amount of the coupling agent used is suitably selected within limits not affecting the conductivity of the conductive particles P. However, it is preferably such an amount that a coating rate (proportion of an area coated with the coupling agent to the surface area of the conductive core particles) of the coupling agent on the surfaces of the conductive particles amounts to at least 5%, more preferably 7 to 100%, still more preferably 10 to 100%, particularly preferably 20 to 100%.

The conductive particles P are preferably contained in the first anisotropically conductive elastomer sheet 25 in a proportion of 5 to 30%, more preferably 7 to 27%, particularly preferably 10 to 25% in terms of volume fraction. When this proportion is at least 5%, conductive paths sufficiently small in electric resistance value in the thickness-wise direction are formed . When the proportion is at most 30% on the other hand, the resulting anisotropically conductive elastomer sheet comes to have necessary elasticity. It is hence preferable to contain the conductive particles P in such a range.

In the first anisotropically conductive elastomer sheet 25, the number of the conductive particles P aligned in the thickness-wise direction (the number of the conductive particles P for forming a conductive path in the thickness-wise direction; hereinafter also referred to as "number of conductive path-forming particles") is preferably 3 to 20 particles, more preferably 5 to 15 particles. When the number of conductive path-forming particles is 3 particles or more, a scatter of an electric resistance value in such an anisotropically conductive elastomer sheet becomes narrow. When the number of conductive path-forming particles is 20 particles or less on the other hand, the deformation of the chains by the conductive particles P does not become great upon compression of such an anisotropically conductive elastomer sheet, and so rise in resistance value is scarcely incurred. It is hence preferable to control the number of the conductive particles within such a range.

Such a first anisotropically conductive elastomer sheet 25 can be produced, for example, in the following manner.

A flowable molding material is first prepared by dispersing conductive particles exhibiting magnetism in a liquid polymeric substance-forming material, which will become an elastic polymeric substance by being cured. This molding material is coated on a proper support, thereby forming a molding material layer on the support. For example, a pair of electromagnets are arranged at an upper position and a lower position of this molding material layer, and the electromagnets are operated, thereby applying a parallel magnetic field to the molding material layer in its thickness-wise direction. As a result, the conductive particles dispersed in the molding material layer are oriented so as to align in the thickness-wise direction while retaining the state dispersed in a plane direction, whereby a plurality of chains by the conductive particles, each extending in the thickness-wise direction are formed in the state dispersed in the plane direction.

In this state, the molding material layer is subjected to a curing treatment, thereby producing the first anisotropically conductive elastomer sheet 25 containing the conductive particles in a state that the conductive particles have been oriented so as to align in the thickness-wise direction in the base material composed of the elastic polymeric substance to form chains and in a state that the chains by the conductive particles have been dispersed in the plane direction.

In the above-described process, the curing treatment of the molding material layer may be conducted in the state that the parallel magnetic field has been applied. However, the treatment may also be conducted after stopping the application of the parallel magnetic field.

The intensity of the parallel magnetic field applied to the molding material is preferably an intensity that it amounts to 0.02 to 2.0 T on the average.

As a means for applying the parallel magnetic field to the molding material layer, permanent magnets may also be used in place of the electromagnets. As such permanent magnets, are preferred those composed of alunico (Fe-Al-Ni-Co alloy), ferrite or the like in that the intensity of the parallel magnetic field within the above range is achieved.

The curing treatment of the molding material layer is suitably selected according to the material used. However, the treatment is generally conducted by a heating treatment. Specific heating temperature and heating time are suitably selected in view of the kinds of the polymeric substance-forming material making up the molding material layer, and the like, the time required for movement of the conductive particles, and the like.

No particular limitation is imposed on the second anisotropically conductive elastomer sheet 26 so far as necessary electrical connection between the terminal electrodes 23 in the wiring board 21 for connection and inspection electrodes formed on the pressing pins 31 in the upper-side pressing pin mechanism 30, which will be described subsequently, is achieved, and any of conventionally known dispersion type anisotropically conductive sheet and uneven distribution type anisotropically conductive sheet may be used.

The thickness of the second anisotropically conductive elastomer sheet 26 is preferably 50 to 500 µm, more preferably 100 to 300 µm.

The upper-side pressing pin mechanism 30 is composed of a great number of pressing pins 31 each formed of a metal and a plate-like pressing pin supporting member 35 for vertically supporting these pressing pins 31. In the embodiment illustrated, the pressing pins 31 are arranged according to positions of lattice points.

As illustrated in Fig. 2, each of the pressing pins 31 has a columnar body part 32, and a columnar projected part 33 having a diameter smaller than that of the body part 32 is formed integrally with the body part 32 on the tip of the body part 32. A disk ring-like flange part 34 is formed integrally with the body part 32 at a central position in a longitudinal direction of the body part 32. In the embodiment illustrated, the projected parts 33 of all the pressing pins 31 are provided as inspection electrodes. An electric wire W is connected to a proximal end of each of the pressing pins 31, and the pressing pin 31 is electrically connected to an inspection circuit (not illustrated) of a tester through this electric wire W.

The pressing pin supporting member 35 is constructed by stacking a proximal-side supporting plate 36 for supporting a proximal portion (indicating a portion on the proximal side from the flange part 34) of the body part 32 in each pressing pin 31 and a tip-side supporting plate 37 for supporting a tip portion (indicating a portion on the tip side from the flange part 34) of the body part 32 in each pressing pin 31 on each other.

In the proximal-side supporting plate 36, a great number of through-holes 36H each extending in its thickness-wise direction and having an inner diameter fitted to the diameter of the body part 32 in the pressing pin 31 and a sectional form of a circle are formed in accordance with a pattern corresponding to an arrangement pattern of the pressing pins 31. The proximal portion in the body part 32 of the pressing pin 31 is inserted into each of these through-holes 36H.

In the tip-side supporting plate 37, circular recesses 37A having a diameter fitted to the diameter of the flange part 34 in the pressing pins 31 are formed in a back surface (upper side in Figs. 1 and 2) thereof in accordance with a pattern corresponding to the arrangement pattern of the pressing pins 31. Through-holes 37H each extending in the thickness-wise direction and having an inner diameter fitted to the diameter of the body part 32 in the pressing pin 31 are formed in the respective bottom surfaces of the recesses 37A in accordance with a pattern corresponding to the arrangement pattern of the pressing pins 31. The tip portion in the body part 32 of the pressing pin 31 is inserted into each of these through-holes 37H, and the flange part 34 of the pressing pin 31 is received in each recess 37A to engage with the bottom surface of the recess 37A, whereby the projected part 33 of the pressing pin 31 is fixed in a state protruded from the surface (lower surface in Figs. 1 and 2) of the tip-side supporting plate 37.

In such an upper-side jig 10 for inspection, a great number of the pressing pins 31 in the upper-side pressing pin mechanism 30 are arranged in such a manner that at least one pressing pin 31 is located in a rectangular region (hereinafter also referred to as "specific electrode region") R1 partitioned by linking central points of adjacent 4 connecting electrodes 22 in the wiring board 21 for connection as illustrated in Fig. 5 when the upper-side pressing pin mechanism 30 and the upper-side adaptor 20 are seen through in the thickness-wise direction thereof. In the embodiment illustrated, one pressing pin 31 is located at a central position in each specific electrode region R1, and a great number of the pressing pins 31 are arranged in such a manner that the tip surface (pressing surface) of the pressing pin 31 do not overlap the connecting electrode 22.

The lower-side jig 40 for inspection is composed of a lower-side adaptor 50 having a wiring board 51 for connection and a lower-side pressing pin mechanism 60 arranged on a back surface side (lower surface side in Figs. 1 and 3) of the wiring board 51 for connection in the lower-side adaptor 50.

The lower-side adaptor 50 is composed of the wiring board 51 for connection, a first anisotropically conductive elastomer sheet 55 arranged on a front surface (upper surface in Figs. 1 and 3) of the wiring board 51 for connection and a second anisotropically conductive elastomer sheet 56 arranged on a back surface of the wiring board 51 for connection and is provided shiftably in a direction (vertical direction) separating from and coming close to the lower-side pressing pin mechanism 60.

On the front surface of the wiring board 51 for connection, a plurality of connecting electrodes 52 are formed in accordance with a pattern corresponding to a pattern of the other surface-side electrodes 3 to be inspected of the circuit board 1 to be inspected. On the back surface of the wiring board 51 for connection, a plurality of terminal electrodes 53 are formed in accordance with a pattern corresponding to an arrangement pattern of pressing pins 61 in the lower-side pressing pin mechanism 60, which will be described subsequently. Each of the connecting electrodes 52 is electrically connected to a suitable terminal electrode 53 through an internal wiring (not illustrated).

As a base material for forming the wiring board 51 for connection, may be use that generally used as a base material for printed wiring boards.

No particular limitation is imposed on the first anisotropically conductive elastomer sheet 55 so far as necessary electrical connection between the connecting electrodes 52 in the wiring board 51 for connection and the other surface-side electrodes 3 to be inspected of the circuit board 1 to be inspected is achieved, and any of conventionally known dispersion type anisotropically conductive sheet and uneven distribution type anisotropically conductive sheet may be used.

The thickness of the first anisotropically conductive elastomer sheet 55 is preferably 30 to 300 µm, more preferably 50 to 200 µm.

No particular limitation is imposed on the second anisotropically conductive elastomer sheet 56 so far as necessary electrical connection between the terminal electrodes 53 in the wiring board 51 for connection and inspection electrodes formed on the pressing pins 61 in the lower-side pressing pin mechanism 60 is achieved, and any of conventionally known dispersion type anisotropically conductive sheet and uneven distribution type anisotropically conductive sheet may be used.

The thickness of the second anisotropically conductive elastomer sheet 56 is preferably 50 to 500 µm, more preferably 100 to 300 µm.

The lower-side pressing pin mechanism 60 is composed of a great number of pressing pins 61 each formed of a metal and a plate-like pressing pin supporting member 65 for vertically supporting these pressing pins 61. In the embodiment illustrated, the pressing pins 61 are arranged according to positions of lattice points. In the present invention, an arrangement pitch between the pressing pins 61 is, for example, 0.2 mm, 0.3 mm, 0.45 mm, 0.5 mm, 0.75 mm, 0.8 mm, 1.06 mm, 1.27 mm, 1.5 mm, 1.8 mm or 2.54 mm.

As illustrated in Fig. 3, each of the pressing pins 61 has a columnar body part 62, and a columnar projected part 63 having a diameter smaller than that of the body part 62 is formed integrally with the body part 62 on the tip of the body part 62 and inspection electrode is formed by the projected part 63. A disk ring-like flange part 64 is formed integrally with the body part 62 at a central position in a longitudinal direction of the body part 62. An electric wire W is connected to a proximal end of each of the pressing pins 61, and the pressing pin 61 is electrically connected to an inspection circuit (not illustrated) of a tester through this electric wire W.

The pressing pin supporting member 65 is constructed by stacking a proximal-side supporting plate 66 for supporting a proximal portion (indicating a portion on the proximal side from the flange part 64) of the body part 62 in each pressing pin 61 and a tip-side supporting plate 67 for supporting a tip portion (indicating a portion on the tip side from the flange part 64) of the body part 62 in each pressing pin 61 on each other.

In the proximal-side supporting plate 66, a great number of through-holes 66H each extending in its thickness-wise direction and having an inner diameter fitted to the diameter of the body part 62 in the pressing pin 61 and a sectional form of a circle are formed in accordance with a pattern corresponding to an arrangement pattern of the pressing pins 61. The proximal portion in the body part 62 of the pressing pin 61 is inserted into each of these through-holes 66H, and the flange part 64 of the pressing pin 61 is engaged with the surface of the proximal-side supporting plate 66.

In the tip-side supporting plate 67, circular recesses 67A having a diameter fitted to the diameter of the flange part 64 are formed in a back surface (lower side in Figs. 1 and 3) thereof in accordance with a pattern corresponding to the arrangement pattern of the pressing pins 61. Through-holes 67H each extending in the thickness-wise direction and having an inner diameter fitted to the diameter of the body part 62 in the pressing pin 61 are formed in the respective bottom surfaces of the recesses 67A in accordance with a pattern corresponding to the arrangement pattern of the pressing pins 61. The tip portion in the body part 62 of the pressing pin 61 is inserted into each of these through-holes 67H, and the flange part 64 of the pressing pin 61 is received in each recess 67A, whereby the projected part 63 of the pressing pin 61 is fixed in a state protruded from the surface (upper surface in Figs. 1 and 3) of the tip-side supporting plate 67.

In the inspection apparatus for circuit board of such construction, electrical inspection of the circuit board 1 to be inspected is performed in the following manner.

The circuit board 1 to be inspected is first arranged in alignment in the inspection region T. More specifically, the electrode circuit board 1 to be inspected is arranged in such a manner that the one surface-side electrodes 2 to be inspected thereof are located just under respective positions of the connecting electrodes 22 of the wiring board 21 for connection in the upper-side adaptor 20, and the other surface-side electrodes 3 to be inspected thereof are located just over respective positions of the connecting electrodes 52 of the wiring board 51 for connection in the lower-side adaptor 50.

Any one or both of the upper-side jig 10 for inspection and the lower-side jig 40 for inspection are then moved in a direction approaching each other, thereby attaining a state that in the upper-side jig 10 for inspection, the upper-side adaptor 20 has been arranged on the upper surface of the circuit board 1 to be inspected in such a manner that the first anisotropically conductive elastomer sheet 25 thereof comes into contact with the circuit board 1 to be inspected, and the upper-side pressing pin mechanism 30 has been arranged on the back surface of the upper-side adaptor 20 in such a manner that one pressing pin 31 is located in a rectangular region (hereinafter also referred to as "specific region of electrodes to be inspected") r partitioned by linking central points of adjacent 4 one surface-side electrodes 2 to be inspected in the circuit board 1 to be inspected as illustrated in Fig. 6 when the upper-side adaptor 20 and the circuit board 1 to be inspected are seen through in the thickness-wise direction thereof. In the embodiment illustrated, there is brought about a state that one pressing pin 31 has been located at a central position in the specific region r of electrodes to be inspected, at the same time that the tip surface (pressing surface) of the pressing pin 31 does not overlap the one surface-side electrode 2 to be inspected.

On the other hand, in the lower-side jig 40 for inspection, there is brought about a state that the lower-side adaptor 50 has been arranged on the lower surface of the circuit board 1 to be inspected in such a manner that the first anisotropically conductive elastomer sheet 55 thereof comes into contact with the circuit board 1 to be inspected, and the lower-side pressing pin mechanism 50 has been arranged on the back surface of the lower-side adaptor 50.

Either one or both of the upper-side jig 10 for inspection and the lower-side jig 40 for inspection are further moved in a direction approaching each other, whereby in the upper-side jig 10 for inspection, the second anisotropically conductive elastomer sheet 26 in the upper-side adaptor 20 is pressed by the respective pressing pins 31 of the upper-side pressing pin mechanism 30, and the one surface-side electrodes 2 to be inspected of the circuit board 1 to be inspected are brought into contact under pressure with the first anisotropically conductive elastomer sheet 25 in the upper-side adaptor 20. On the other hand, in the lower-side jig 40 for inspection, the second anisotropically conductive elastomer sheet 56 in the lower-side adaptor 50 is pressed by the respective pressing pins 61 of the lower-side pressing pin mechanism 60, and the other surface-side electrodes 3 to be inspected of the circuit board 1 to be inspected are brought into contact under pressure with the first anisotropically conductive elastomer sheet 55 in the lower-side adaptor 50.

In such a state, in the first anisotropically conductive elastomer sheet 25 in the upper-side adaptor 20, conductive paths by the conductive particles each extending in the thickness-wise direction thereof are formed at portions with which the one surface-side electrodes 2 to be inspected have been brought into contact under pressure. As a result, electrical connection of the respective one surface-side electrodes 2 to be inspected of the circuit board 1 to be inspected to their corresponding connecting electrodes 22 of the wiring board 21 for connection is achieved. In the second anisotropically conductive elastomer sheet 26, conductive paths by the conductive particles each extending in the thickness-wise direction thereof are formed at portions pressed by the pressing pins 31. As a result, electrical connection of the respective inspection electrodes (projected parts 33) formed on the pressing pins 31 to their corresponding terminal electrodes 23 of the wiring board 21 for connection is achieved, whereby each of the one surface-side electrodes 2 to be inspected of the circuit board 1 to be inspected is electrically connected to an inspection circuit of a tester. On the other hand, in the first anisotropically conductive elastomer sheet 55 in the lower-side adaptor 50, conductive paths by the conductive particles each extending in the thickness-wise direction thereof are formed at portions with which the other surface-side electrodes 3 to be inspected have been brought into contact under pressure. As a result, electrical connection of the respective other surface-side electrodes 3 to be inspected of the circuit board 1 to be inspected to their corresponding connecting electrodes 52 of the wiring board 51 for connection is achieved. In the second anisotropically conductive elastomer sheet 56, conductive paths by the conductive particles each extending in the thickness-wise direction thereof are formed at portions pressed by the pressing pins 61. As a result, electrical connection of the respective inspection electrodes (projected parts 63) formed on the pressing pins 61 to their corresponding terminal electrodes 53 of the wiring board 51 for connection is achieved, whereby each of the other surface-side electrodes 3 to be inspected of the circuit board 1 to be inspected is electrically connected to the inspection circuit of the tester. This state is an inspectable state.

In such a manner, the inspectable state that each of the one surface-side electrodes 2 to be inspected of the circuit board 1 to be inspected has been electrically connected to the inspection circuit of the tester through the upper-side adaptor 20 and the pressing pin 31 of the upper-side pressing pin mechanism 30, and each of the other surface-side electrodes 3 to be inspected of the circuit board 1 to be inspected has been electrically connected to the inspection circuit of the tester through the lower-side adaptor 50 and the pressing pin 61 of the lower-side pressing pin mechanism is attained. In this inspectable state, necessary electrical inspection on the circuit board 1 to be inspected is carried out.

In the above-described inspectable state, the wiring board 21 for connection in the upper-side adaptor 20 is curved in such a manner that portions being applied with the pressing force by the pressing pins 31 of the upper-side pressing pin mechanism 30 and the one surface-side electrodes 2 to be inspected of the circuit board 1 to be inspected are shifted in pressing directions. In other words, as typically illustrated in Fig. 7, the wiring board 21 for connection in the upper-side adaptor 20 is forcedly deformed in the form of a regular wave to function as the so-called plate spring. As a result, the pressing force applied to the first anisotropically conductive elastomer sheet 25 is relaxed by virtue of the spring elasticity of the wiring board 21 for connection even when the projected height of the one surface-side electrodes 2 to be inspected varies, whereby excessive pressing force is applied to a part of the first anisotropically conductive elastomer sheet 25.

Accordingly, according to the inspection apparatus for circuit board of the present invention, the first anisotropically conductive elastomer sheet 25 is prevented from causing trouble prematurely, and long service life that the anisotropically conductive elastomer sheet is designed to have can be obtained even when the projected height of the one surface-side electrodes 2 to be inspected of the circuit board 1 to be inspected varies, and that having a small thickness is used as the first anisotropically conductive elastomer sheet 25.

In addition, in the above-described inspectable state, the wiring board 21 for connection is deformed according to the projected height of each one surface-side electrode 2 to be inspected of the circuit board 1 to be inspected even when the projected height of the one surface-side electrodes 2 to be inspected varies, so that the scatter of the projected height in the one surface-side electrodes 2 to be inspected is sufficiently absorbed even when that having a small thickness is used as the first anisotropically conductive elastomer sheet 25.

Accordingly, according to the inspection apparatus for circuit board of the present invention, stable electrical connection is attained to all the one surface-side electrodes 2 to be inspected, and inspection can be carried out with high reliability even when the circuit board 1 to be inspected has one surface-side electrodes 2 to be inspected arranged at a small pitch, and the projected height of the one surface-side electrodes 2 to be inspected varies.

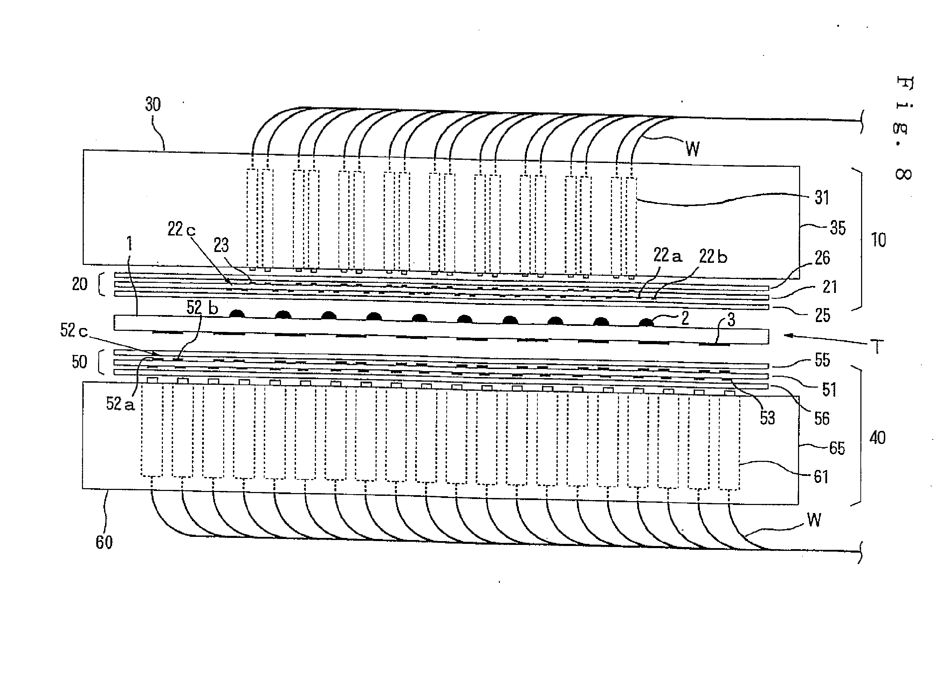

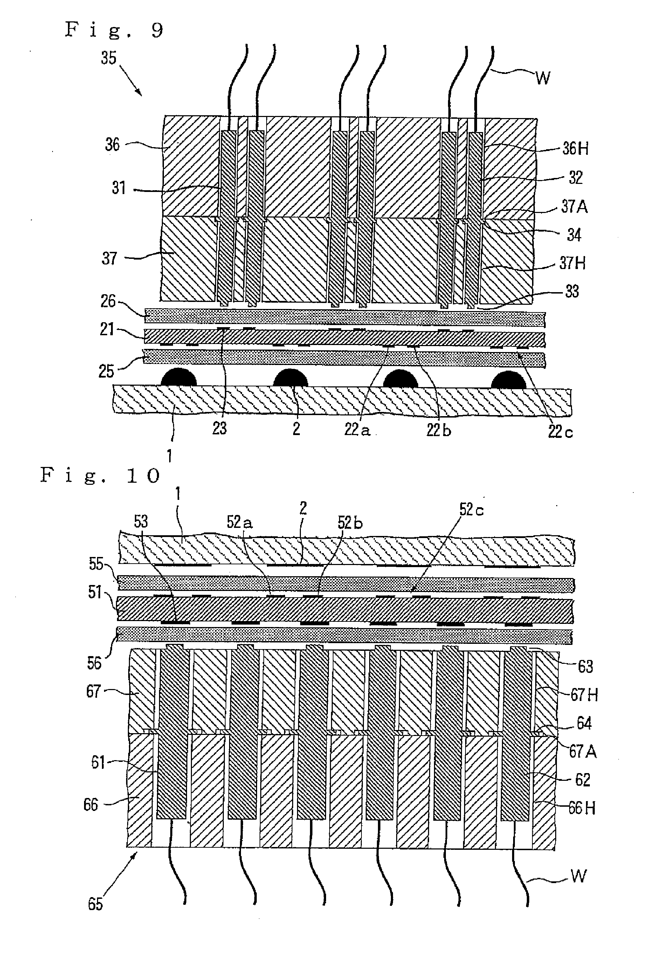

Fig. 8 illustrates the construction of an inspection apparatus for circuit board according to a second embodiment of the present invention together with a circuit board that is an object of inspection, Fig. 9 illustrates, on an enlarged scale, a principal part of an upper-side jig for inspection in the inspection apparatus for circuit board shown in Fig. 8, and Fig. 10 illustrates, on an enlarged scale, a principal part of a lower-side jig for inspection in the inspection apparatus for circuit board shown in Fig. 8. This inspection apparatus for circuit board is used for carrying out an electric resistance-measuring test as to a circuit board 1 to be inspected.

The circuit board 1 to be inspected subjected to this inspection apparatus for circuit board is a circuit board for making up, for example, a packaged LSI such as BGA and having, on one surface (upper surface in Fig. 8) thereof, a plurality of projected one surface-side electrodes 2 to be inspected arranged in lattice and, on the other surface (lower surface in Fig. 8) thereof, a plurality of flat plate-like other surface-side electrodes 3 to be inspected arranged according to positions of lattice points. A semiconductor chip is mounted on the one surface thereof by the flip chip mounting method, and solder ball electrodes are formed on the other surface-side electrodes 3 to be inspected to form BGA.

In this inspection apparatus for circuit board, an upper-side jig 10 for inspection is provided above an inspection-executing region T in which the circuit board 1 to be inspected is horizontally arranged. On the other hand, a lower-side jig 40 for inspection is provided below the inspection-executing region T. The upper-side jig 10 for inspection and lower-side jig 40 for inspection are supported by proper supporting mechanisms (not illustrated), whereby the upper-side jig 10 for inspection and lower-side jig 40 for inspection are arranged so as to oppose to each other in a vertical direction.

The upper-side jig 10 for inspection is composed of an upper-side adaptor 20 having a wiring board 21 for connection and an upper-side pressing pin mechanism 30 arranged on a back surface side (upper surface side in Figs. 8 and 9) of the wiring board 21 for connection in the upper-side adaptor 20.

The upper-side adaptor 20 is composed of the wiring board 21 for connection, a first anisotropically conductive elastomer sheet 25 arranged on a front surface (lower surface in Figs. 8 and 9) of the wiring board 21 for connection and a second anisotropically conductive elastomer sheet 26 arranged on a back surface of the wiring board 21 for connection and is provided shiftably in a direction (vertical direction) separating from and coming close to the upper-side pressing pin mechanism 30.

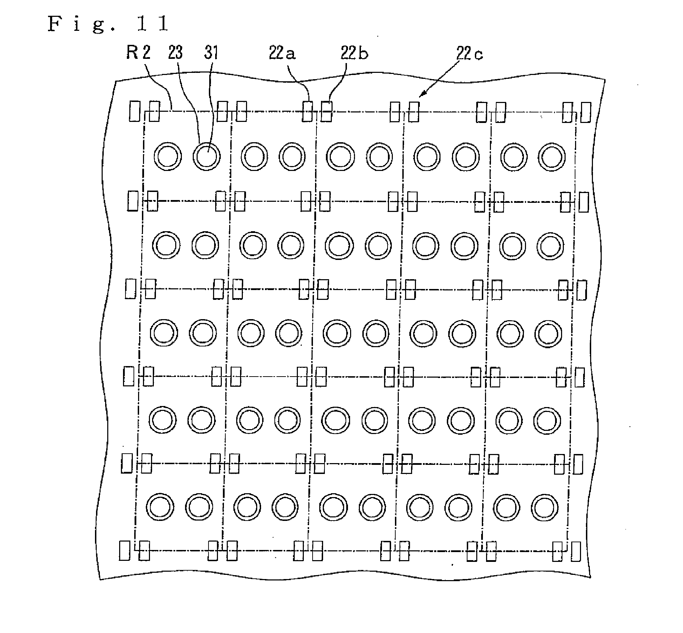

On the front surface of the wiring board 21 for connection, plural pairs of connecting electrodes 22c each composed of a pair of a connecting electrode 22a for current supply and a connecting electrode 22b for voltage measurement arranged in relation separated from each other are formed in accordance with a pattern corresponding to a pattern of the one surface-side electrodes 2 to be inspected of the circuit board 1 to be inspected. On the back surface of the wiring board 21 for connection, terminal electrodes 23 are formed at respective pressing positions by pressing pins 31 in the upper-side pressing pin mechanism 30, which will be described subsequently. More specifically, the terminal electrodes 23 are formed in accordance with a pattern corresponding to an arrangement pattern of the pressing pins 31 in the upper-side pressing pin mechanism 30, two terminal electrodes 23 are located in a rectangular region partitioned by linking central points of adjacent 4 pairs of connecting electrodes 22c in the wiring board 21 for connection when the wiring board 21 for connection is seen through in a thickness-wise direction thereof, and each of the terminal electrodes 23 is arranged so as not to overlap each of the connecting electrode 22a for current supply and the connecting electrode 22b for voltage measurement (see Fig. 11).

In the embodiment illustrated, the connecting electrodes 22a for current supply and the connecting electrodes 22b for voltage measurement are electrically connected to the terminal electrodes 23 in relation of one to one. More specifically, one connecting electrode 22a for current supply is electrically connected to one terminal electrode 23, and one connecting electrodes 22b for voltage measurement is electrically connected to one terminal electrode 23. In an actual construction, however, the electrical connection between the connecting electrodes 22a for current supply and the connecting electrodes 22b for voltage measurement, and the terminal electrodes 23 may be achieved according to the wiring pattern of the circuit board 1 to be inspected and the purpose of inspection. Accordingly, all the connecting electrodes 22a for current supply and connecting electrodes 22b for voltage measurement and the terminal electrodes 23 do not always need to be electrically connected to each other in relation of one to one. For example, a plurality of connecting electrodes 22a for current supply may be electrically connected to a terminal electrode 23 through a common internal wiring.

The wiring board 21 for connection preferably has flexibility to the extent that it is curved in such a manner that when the upper-side adaptor 20 is held under pressure by the respective pressing pins 31 in the pressing pin mechanism 30, which will be described subsequently, and the respective one surface-side electrodes 2 to be inspected of the circuit board 1 to be inspected, portions being applied with the pressing force by the respective pressing pins 31 and the respective electrodes 2 to be inspected are shifted in pressing directions.

The degree of specific flexibility required of the wiring board 21 for connection is suitably set in view of the diameter, pitch and the like of the one surface-side electrodes 2 to be inspected of the electrode 1 to be inspected.

The material and thickness of a base material of the wiring board 21 for connection are the same as in the wiring board for connection in the upper-side adaptor of the inspection apparatus for circuit board according to the first embodiment.

The first anisotropically conductive elastomer sheet 25 and second anisotropically conductive elastomer sheet 26 have the same construction as the first anisotropically conductive elastomer sheet and second anisotropically conductive elastomer sheet in the upper-side adaptor of the inspection apparatus for circuit board according to the first embodiment.

The upper-side pressing pin mechanism 30 is composed of a great number of pressing pins 31 each formed of a metal and a plate-like pressing pin supporting member 35 for vertically supporting these pressing pins 31 and is basically of the same construction as the upper-side pressing pin mechanism of the inspection apparatus for circuit board according to the first embodiment except for the arrangement pattern of the pressing pins 31. An electric wire W is connected to a proximal end of each of the pressing pins 31, and the pressing pin 31 is electrically connected to an inspection circuit (not illustrated) of a tester through this electric wire W.

In such an upper-side jig 10 for inspection, a great number of the pressing pins 31 in the upper-side pressing pin mechanism 30 are arranged in such a manner that at least one pressing pin 31 is located in a rectangular region (hereinafter also referred to as "specific electrode pair region") R2 partitioned by linking central points of adjacent 4 pairs of connecting electrodes 22c in the wiring board 21 for connection as illustrated in Fig. 11 when the upper-side pressing pin mechanism 30 and the upper-side adaptor 20 are seen through in the thickness-wise direction thereof. In the embodiment illustrated, two pressing pins 31 are located in each specific electrode pair region R2, and a great number of the pressing pins 31 are arranged in such a manner that the tip surface (pressing surface) of each of the pressing pins 31 do not overlap the connecting electrode 22a for current supply and connecting electrode 22b for voltage measurement in the pair of connecting electrodes 22c.

The lower-side jig 40 for inspection is composed of a lower-side adaptor 50 having a wiring board 51 for connection and a lower-side pressing pin mechanism 60 arranged on a back surface side (lower surface side in Figs. 8 and 10) of the wiring board 51 for connection in the lower-side adaptor 50.

The lower-side adaptor 50 is composed of the wiring board 51 for connection, a first anisotropically conductive elastomer sheet 55 arranged on a front surface (upper surface in Figs. 8 and 10) of the wiring board 51 for connection and a second anisotropically conductive elastomer sheet 56 arranged on a back surface of the wiring board 51 for connection and is provided shiftably in a direction (vertical direction) separating from and coming close to the lower-side pressing pin mechanism 60.

On the front surface of the wiring board 51 for connection, plural pairs of connecting electrodes 52c each composed of a connecting electrode 52a for current supply and a connecting electrode 52b for voltage measurement are formed in accordance with a pattern corresponding to a pattern of the other surface-side electrodes 3 to be inspected of the circuit board 1 to be inspected. On the back surface of the wiring board 51 for connection, a plurality of terminal electrodes 53 are formed in accordance with a pattern corresponding to an arrangement pattern of pressing pins 61 in the lower-side pressing pin mechanism 60, which will be described subsequently. Each of the connecting electrode 52a for current supply and the connecting electrode 52b for voltage measurement is electrically connected to a suitable terminal electrode 53 through an internal wiring (not illustrated).

As a base material for forming the wiring board 51 for connection, may be used that generally used as a base material for printed wiring boards.

The first anisotropically conductive elastomer sheet 25 and second anisotropically conductive elastomer sheet 26 have the same construction as the first anisotropically conductive elastomer sheet and second anisotropically conductive elastomer sheet in the lower-side adaptor of the inspection apparatus for circuit board according to the first embodiment.

The lower-side pressing pin mechanism 60 is composed of a great number of pressing pins 61 each formed of a metal and a plate-like pressing pin supporting member 65 for vertically supporting these pressing pins 61 and is basically of the same construction as the lower-side pressing pin mechanism of the inspection apparatus for circuit board according to the first embodiment except for the arrangement pattern of the pressing pins 31.

In the inspection apparatus for circuit board of such construction, electrical inspection of the circuit board 1 to be inspected, specifically, electric resistance measurement of each circuit formed between the one surface-side electrodes 2 to be inspected and the other surface-side electrodes 3 to be inspected in the circuit board 1 to be inspected is performed in the following manner.

The circuit board 1 to be inspected is first arranged in alignment with the inspection region T. More specifically, the circuit board 1 to be inspected is arranged in such a manner that the one surface-side electrodes 2 to be inspected thereof are located just under respective positions of the pairs of connecting electrodes 22c of the wiring board 21 for connection in the upper-side adaptor 20, and the other surface-side electrodes 3 to be inspected thereof are located just over respective positions of the pairs of connecting electrodes 52c of the wiring board 51 for connection in the lower-side adaptor 50.

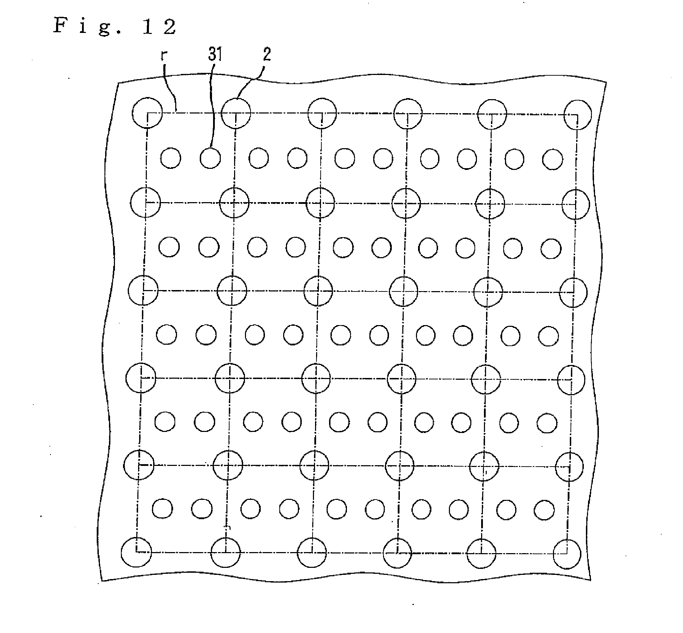

Any one or both of the upper-side jig 10 for inspection and the lower-side jig 40 for inspection are then moved in a direction approaching each other, thereby attaining a state that in the upper-side jig 10 for inspection, the upper-side adaptor 20 has been arranged on the front surface of the circuit board 1 to be inspected in such a manner that the first anisotropically conductive elastomer sheet 25 thereof comes into contact with the circuit board 1 to be inspected, and the upper-side pressing pin mechanism 30 has been arranged on the back surface of the upper-side adaptor 20 in such a manner that two pressing pins 31 are located in a specific region r of electrodes to be inspected as illustrated in Fig. 12 when the upper-side adaptor 20 and the circuit board 1 to be inspected are seen through in the thickness-wise direction thereof. In the embodiment illustrated, there is brought about a state that the upper-side pressing pin mechanism 30 has been arranged in such a manner that the tip surface (pressing surface) of the pressing pin 31 does not overlap the one surface-side electrode 2 to be inspected.

On the other hand, in the lower-side jig 40 for inspection, there is brought about a state that the lower-side adaptor 50 has been arranged on the lower surface of the circuit board 1 to be inspected in such a manner that the first anisotropically conductive elastomer sheet 55 thereof comes into contact with the circuit board 1 to be inspected, and the lower-side pressing pin mechanism 50 has been arranged on the back surface of the lower-side adaptor 50.

Any one or both of the upper-side jig 10 for inspection and the lower-side jig 40 for inspection are further moved in a direction approaching each other, whereby in the upper-side jig 10 for inspection, the second anisotropically conductive elastomer sheet 26 in the upper-side adaptor 20 is pressed by the respective pressing pins 31 of the upper-side pressing pin mechanism 30, and the one surface-side electrodes 2 to be inspected of the circuit board 1 to be inspected are brought into contact under pressure with the first anisotropically conductive elastomer sheet 25 in the upper-side adaptor 20. On the other hand, in the lower-side jig 40 for inspection, the second anisotropically conductive elastomer sheet 56 in the lower-side adaptor 50 is pressed by the respective pressing pins 61 of the lower-side pressing pin mechanism 60, and the other surface-side electrodes 3 to be inspected of the circuit board 1 to be inspected are brought into contact under pressure with the first anisotropically conductive elastomer sheet 55 in the lower-side adaptor 50.

In such a state, in the first anisotropically conductive elastomer sheet 25 in the upper-side adaptor 20, conductive paths by the conductive particles each extending in the thickness-wise direction thereof are formed at portions with which the one surface-side electrodes 2 to be inspected have been brought into contact under pressure. As a result, both electrode 22a for current supply and electrode 22b for voltage measurement in each pair of connecting electrodes 22c of the wiring board 21 for connection are electrically connected to each of the one surface-side electrodes 2 to be inspected of the circuit board 1 to be inspected at the same time. In the second anisotropically conductive elastomer sheet 26, conductive paths by the conductive particles each extending in the thickness-wise direction thereof are formed at portions pressed by the pressing pins 31. As a result, electrical connection of the respective inspection electrodes (projected parts 33) formed on the pressing pins 31 to their corresponding terminal electrodes 23 of the wiring board 21 for connection is achieved, whereby each of the one surface-side electrodes 2 to be inspected of the circuit board 1 to be inspected is electrically connected to an inspection circuit of a tester. On the other hand, in the first anisotropically conductive elastomer sheet 55 in the lower-side adaptor 50, conductive paths by the conductive particles each extending in the thickness-wise direction thereof are formed at portions with which the other surface-side electrodes 3 to be inspected have been brought into contact under pressure. As a result, both electrode 52a for current supply and electrode 52b for voltage measurement in each pair of connecting electrodes 52c of the wiring board 51 for connection are electrically connected to each of the one surface-side electrodes 3 to be inspected of the circuit board 1 to be inspected at the same time. In the second anisotropically conductive elastomer sheet 56, conductive paths by the conductive particles each extending in the thickness-wise direction thereof are formed at portions pressed by the pressing pins 61. As a result, electrical connection of the respective inspection electrodes (projected parts 63) formed on the pressing pins 61 to their corresponding terminal electrodes 53 of the wiring board 51 for connection is achieved, whereby each of the other surface-side electrodes 3 to be inspected of the circuit board 1 to be inspected is electrically connected to the inspection circuit of the tester. This state is an inspectable state.

In such a manner, the inspectable state that each of the one surface-side electrodes 2 to be inspected of the circuit board 1 to be inspected has been electrically connected to the inspection circuit of the tester through the upper-side adaptor 20 and the pressing pin 31 of the upper-side pressing pin mechanism 30, and each of the other surface-side electrodes 3 to be inspected of the circuit board 1 to be inspected has been electrically connected to the inspection circuit of the tester through the lower-side adaptor 50 and the pressing pin 61 of the lower-side pressing pin mechanism 60 is attained. In this inspectable state, necessary electrical inspection on the circuit board 1 to be inspected is carried out. More specifically, a current of a constant value is supplied between the connecting electrodes 21a for current supply of the wiring board 21 for connection in the upper-side adaptor 20 and the connecting electrodes 51a for current supply of the wiring board 51 for connection in the lower-side adaptor 50, and at the same time, one connecting electrode among a great number of the connecting electrodes 22b for voltage measurement of the wiring board 21 for connection in the upper-side adaptor 20 is designated to measure voltage between the designated one connecting electrode 22b for voltage measurement and a connecting electrode 52b for voltage measurement of the wiring board 51 for connection in the lower-side adaptor 50, which has been electrically connected to an other surface-side electrode 3 to be inspected corresponding to a one surface-side electrode 2 to be inspected, which has been electrically connected to the designated connecting electrode 22b for voltage measurement, thereby obtaining an electric resistance value of a circuit formed between the one surface-side electrode 2 to be inspected, which has been electrically connected to the designated one connecting electrode 22b for voltage measurement, and the other surface-side electrode 3 to be inspected corresponding to this electrode on the basis of the thus-obtained voltage value. The connecting electrode 22b for voltage measurement to be designated is successively changed, thereby conducting measurement of electric resistances of circuits respectively formed between all the one surface-side electrodes 2 to be inspected and their corresponding other surface-side electrodes 3 to be inspected.

In the above-described inspectable state, the wiring board 21 for connection in the upper-side adaptor 20 is curved in such a manner that portions being applied with the pressing force by the pressing pins 31 of the upper-side pressing pin mechanism 30 and the one surface-side electrodes 2 to be inspected of the circuit board 1 to be inspected are shifted in pressing directions. In other words, the wiring board 21 for connection in the upper-side adaptor 20 is forcedly deformed in the form of a regular wave to function as the so-called plate spring. As a result, the pressing force applied to the first anisotropically conductive elastomer sheet 25 is relaxed by virtue of the spring elasticity of the wiring board 21 for connection even when the projected height of the one surface-side electrodes 2 to be inspected varies, whereby excessive pressing force is applied to a part of the first anisotropically conductive elastomer sheet 25.

Accordingly, according to the inspection apparatus for circuit board of the present invention, the first anisotropically conductive elastomer sheet 25 is prevented from causing trouble prematurely, and long service life that the anisotropically conductive elastomer sheet is originally designed to have can be obtained even when the projected height of the one surface-side electrodes 2 to be inspected of the circuit board 1 to be inspected varies, and that having a small thickness is used as the first anisotropically conductive elastomer sheet 25.

In addition, in the above-described inspectable state, the wiring board 21 for connection is deformed according to the projected height of each one surface-side electrode 2 to be inspected even when the circuit board 1 to be inspected is such that the projected height of the one surface-side electrodes 2 to be inspected varies, so that the scatter of the projected height in the one surface-side electrodes 2 to be inspected is sufficiently absorbed even when that having a small thickness is used as the first anisotropically conductive elastomer sheet 25.

Accordingly, according to the inspection apparatus for circuit board of the present invention, stable electrical connection is attained to all the one surface-side electrodes 2 to be inspected, and measurement of electric resistance can be carried out with high reliability even when the circuit board 1 to be inspected has one surface-side electrodes 2 to be inspected arranged at a small pitch, and the projected height of the one surface-side electrodes 2 to be inspected varies.

The present invention is not limited to the inspection apparatus for circuit board according to the first embodiment and the inspection apparatus for circuit board according to the second embodiment, and various modifications can be added thereto.

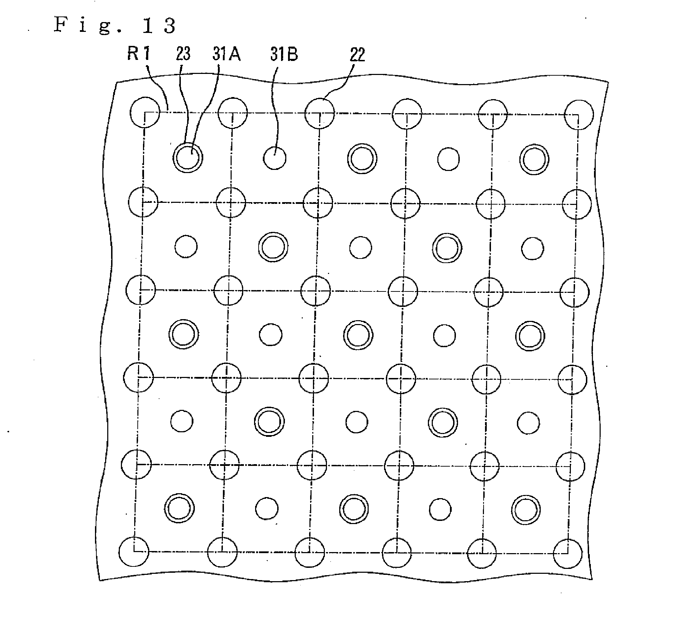

For example, in each of the inspection apparatus for circuit board according to the first embodiment and the inspection apparatus for circuit board according to the second embodiment, the terminal electrodes are formed on the back surface of the wiring board 21 for connection in the upper-side adaptor 20 in accordance with the pattern corresponding to the arrangement pattern of the pressing pins in the upper-side pressing pin mechanism, and the inspection electrodes are formed on the tips of all the pressing pins in the upper-side pressing pin mechanism. However, such construction is not essential. For example, no inspection electrode may be formed on the tips of all the pressing pins. Further, as illustrated in Fig. 13, terminal electrodes 23 may be formed on the back surface of the wiring board 21 for connection in the upper-side adaptor at pressing positions of specific pressing pins (hereinafter referred to as "specific pressing pins") 31A selected from among all the pressing pins in the upper-side pressing pin mechanism, inspection electrodes may be formed on the tips of the specific pressing pins 31A, and no inspection electrode may be formed on the tips of other pressing pins 31B than the specific pressing pins 31A.

An uneven distribution type anisotropically conductive sheet may be used as the first anisotropically conductive elastomer sheet in the upper-side adaptor.

In the circuit board, which is the object of inspection, all the electrodes to be inspected may be arranged at positions of lattice points of the same pitch, or a part of the electrodes to be inspected may be arranged at positions of lattice points of the same pitch. In the circuit board, which is the object of inspection, it is not essential to arrange the electrodes to be inspected at positions of all lattice points in a primitive lattice, and no electrode to be inspected may be arranged at positions of a part of lattice points. In the circuit board, which is the object of inspection, may also be formed a plurality of regions of electrodes to be inspected, in which electrodes to be inspected are arranged in accordance with positions of respective lattice points of different pitches.

### EXAMPLES

The present invention will hereinafter be described specifically by the following Examples. However, the present invention is not limited to the following Examples.

### <Example 1>

An inspection apparatus for circuit board of the following specification was produced in accordance with the construction shown in Figs. 1 to 3.

### [Upper-side adaptor (20)]

A wiring board (21) for connection is such that a material of its base material is a glass fiber-reinforced epoxy resin, the thickness is 200 µm, it has 596 circular connecting electrodes (22) and 596 circular terminal electrodes (23), a diameter of a minimum connecting electrode (22) is 120 µm, a minimum pitch between the connecting electrodes (22) is 200 µm, a diameter of the terminal electrodes (23) is 100 µm, and a minimum pitch between the terminal electrodes (33) is 200 µm. The terminal electrodes (23) are arranged in such a manner that one terminal electrode (23) is located at a central position in a specific electrode region (R1) when the wiring board (21) for connection is seen through in a thickness-wise direction thereof, and the terminal electrode (23) is arranged so as not to overlap the connecting electrode (22) (see Fig. 5).

A first anisotropically conductive elastomer sheet (25) is a dispersion type anisotropically conductive sheet obtained by containing nickel particles (average particle diameter: 10 µm; coating amount of gold: 4% by weight) plated with gold in a proportion of 25% in terms of volume fraction in silicone rubber and having a thickness of 100 µm. As the silicone rubber, was used a cured product of two-pack type addition type liquid silicone rubber, whose compression set was 5% at 150°C and whose tear strength was at least 25 kN/m at 23°C.

A second anisotropically conductive elastomer sheet (26) is a dispersion type anisotropically conductive sheet obtained by containing nickel particles (average particle diameter: 20 µm; coating amount of gold: 4% by weight) plated with gold in a proportion of 20% in terms of volume fraction in silicone rubber and having a thickness of 200 µm. As the silicone rubber, was used a cured product of two-pack type addition type liquid silicone rubber, whose compression set was 5% at 150°C and whose tear strength was at least 25 kN/m at 23°C.

### [Upper-side pressing pin mechanism (30)]

The total number of pressing pins (31) is 596, each of them is composed of brass plated with gold, the overall length [length from a proximal surface of a body part (32) to a tip surface of a projected part (33)] thereof is 6.1 mm, and the projected part (33) is provided as an inspection electrode. The specific dimensions of the respective parts in the pressing pin (31) are as follows. An outer diameter of the projected part (33) is 50 µm, a length (thickness of the inspection electrode) of the projected part (33) is 100 µm, an outer diameter of the body part (32) is 60 µm, a length of the body part (32) is 6 mm, an outer diameter of a flange part (34) is 70 µm, a thickness of the flange part (34) is 100 µm, a length [length of a proximal portion in the body part (32)] from a proximal end to a proximal-side end surface of the flange part (34) in the body part (32) is 3 mm, a length [length of a tip portion in the body part (32)] from a tip end to a tip-side end surface of the flange part (34) in the body part (32) is 2.9 mm, and a minimum arrangement pitch between the pressing pins (31) is 200 µm.

A pressing pin supporting member (35) is composed of a glass fiber-reinforced epoxy resin, a proximal-side supporting plate (36) has dimensions of 70 mm by 70 mm by 10 mm, and a tip-side supporting plate (37) has dimensions of 50 mm by 50 mm by 3 mm. The upper-side pressing pin mechanism (30) is arranged in such a manner that one pressing pin (31) is located at a central position in a specific electrode region R1 when the upper-side pressing pin mechanism (30) and the upper-side adaptor (20) are seen through in the thickness-wise direction thereof, and the tip surface (pressing surface) of the pressing pin (31) does not overlap the connecting electrode (22) (see Fig. 5).

### [Lower-side adaptor (50)]

A wiring board (51) for connection is such that a material of its base material is a glass fiber-reinforced epoxy resin, the thickness is 200 µm, it has 400 circular connecting electrodes (52) and 400 circular terminal electrodes (53), a diameter of a minimum connecting electrode (52) is 500 µm, a minimum pitch between the connecting electrodes (52) is 1,000 µm, a diameter of the terminal electrodes (53) is 500 µm, and a pitch between the terminal electrodes (53) is 1,000 µm.

A first anisotropically conductive elastomer sheet (55) is a dispersion type anisotropically conductive sheet obtained by containing nickel particles (average particle diameter: 10 µm; coating amount of gold: 4% by weight) plated with gold in a proportion of 25% in terms of volume fraction in silicone rubber and having a thickness of 100 µm. As the silicone rubber, was used a cured product of two-pack type addition type liquid silicone rubber, whose compression set was 5% at 150°C and whose tear strength was at least 25 kN/m at 23°C.

A second anisotropically conductive elastomer sheet (56) is a dispersion type anisotropically conductive sheet obtained by containing nickel particles (average particle diameter: 20 µm; coating amount of gold: 4% by weight) plated with gold in a proportion of 25% in terms of volume fraction in silicone rubber and having a thickness of 200 µm. As the silicone rubber, was used a cured product of two-pack type addition type liquid silicone rubber, whose compression set was 5% at 150°C and whose tear strength was at least 25 kN/m at 23°C.

### [Lower-side pressing pin mechanism (60)]

The total number of pressing pins (61) is 400, each of them is composed of brass plated with gold, the overall length [length from a proximal surface of a body part (62) to a tip surface of a projected part (63)] thereof is 6.1 mm, and the projected part (63) is provided as an inspection electrode. The specific dimensions of the respective parts in the pressing pin (61) are as follows. An outer diameter of the projected part (63) is 50 µm, a length (thickness of the inspection electrode) of the projected part (63) is 100 µm, an outer diameter of the body part (62) is 60 µm, a length of the body part (62) is 6 mm, an outer diameter of a flange part (64) is 70 µm, a thickness of the flange part (64) is 100 µm, a length [length of a proximal portion in the body part (62)] from a proximal end to a proximal-side end surface of the flange part (64) in the body part (62) is 3 mm, a length [length of a tip portion in the body part (62)] from a tip end to a tip-side end surface of the flange part (64) in the body part (62) is 2.9 mm, and an arrangement pitch between the pressing pins (61) is 1,000 µm.

A pressing pin supporting member (65) is composed of a glass fiber-reinforced epoxy resin, a proximal-side supporting plate (66) has dimensions of 70 mm by 70 mm by 10 mm, and a tip-side supporting plate (67) has dimensions of 50 mm by 50 mm by 3 mm.

### [Evaluation of inspection apparatus for circuit board]

With respect to the above-described inspection apparatus for circuit board, a connection stability test and a durability test were conducted by means of a circuit board for evaluation of the following specification in accordance with the following respective methods.

### [Specification of circuit board for evaluation]

The overall dimensions of the circuit board for evaluation are 30 mm by 30 mm by 1 mm, semispherical one surface-side electrodes to be inspected are arranged in lattice on one surface thereof, the total number of the electrodes is 596, a diameter of a minimum one surface-side electrode to be inspected is 100 µm, a minimum pitch thereof is 200 µm, flat plate-like other surface-side electrodes to be inspected are arranged in lattice at a pitch of 1 mm on the other surface thereof, the total number of the electrodes is 400, and a diameter of the other surface-side electrode to be inspected is 500 µm. The projected height of the one surface-side electrodes to be inspected is about 60 µm on the average, its maximum value is about 80 µm, and its minimum value is about 40 µm. This circuit board for evaluation is referred to as "Circuit Board (W1)".

### [Connection stability test]

The inspection apparatus for circuit board was installed in an inspection section of a Step-and-Repeat Testing System for BGM-MCM ("GATS-7300", manufactured by NIDEC-READ CORPORATION), and Circuit Board (W1) was set in an inspection region of the inspection apparatus for circuit board. A pressing operation was conducted for Circuit Board (W1) under a prescribed press load. In this state, an electric resistance value as to Circuit Board (W1) when a current of 1 mA was applied between each of the connecting electrodes of the wiring board for connection in the upper-side adaptor and its corresponding connecting electrode of the wiring board for connection in the lower-side adaptor was measured to count the number of inspection points (hereinafter referred to as "NG inspection points") at which the electric resistance value measured reached 100 Ω or higher. After this operation of counting the NG inspection points was repeated 10 times in total, a proportion (hereinafter referred to as "proportion of NG inspection points") of the number of the NG inspection points to the total number of inspection points was calculated out. The step of calculating out such a proportion of NG inspection points was conducted by changing the press load stepwise in a range of 10 to 22.5kg, thereby determining a minimum press load under which the proportion of NG inspection points was 0.01% or lower. In actual inspection of circuit boards, it is necessary that the proportion of NG inspection points is 0.01% or lower. If the proportion of NG inspection points exceeds 0.01%, there is a possibility that a nondefective circuit board to be inspected may be judged to be a defective. It is hence difficult to conduct electrical inspection as to circuit board with high reliability.

The press load determined in such a manner is referred to as "connectable load". The smaller connectable load value indicates that the connection stability is higher.

The results of the above-described connection stability test are shown in Table 1.

### [Durability test]

The inspection apparatus for circuit board was installed in an inspection section of a Step-and-Repeat Testing System for BGM-MCM ("GATS-7300", manufactured by NIDEC-READ CORPORATION), and Circuit Board (W1) was set in an inspection region of the inspection apparatus for circuit board. After a pressing operation was then conducted prescribed times for Circuit Board (W1) under a load of 10 kgf, an electric resistance value as to Circuit Board (W1) when a current of 1 mA was applied between each of the connecting electrodes of the wiring board for connection in the upper-side adaptor and its corresponding connecting electrode of the wiring board for connection in the lower-side adaptor was measured under conditions of 10 kgf load. The number of inspection points (NG inspection points) at which the electric resistance value measured reached 100 Ω or higher was counted to calculate out a proportion (proportion of NG inspection points) of the number of the NG inspection points to the total number of inspection points. The process of calculating out such a proportion of NG inspection points was conducted repeatedly 10,000 times.

A proportion of NG inspection points was determined in the same manner as described above except that the anisotropically conductive sheets in the inspection apparatus were replaced by new ones, and the press load in the pressing operation and electric resistance-measuring operation were changed to 17.5 kg and 22.5 kgf.

The results of the above-described durability test are shown in Table 2.

### <Comparative Example 1>

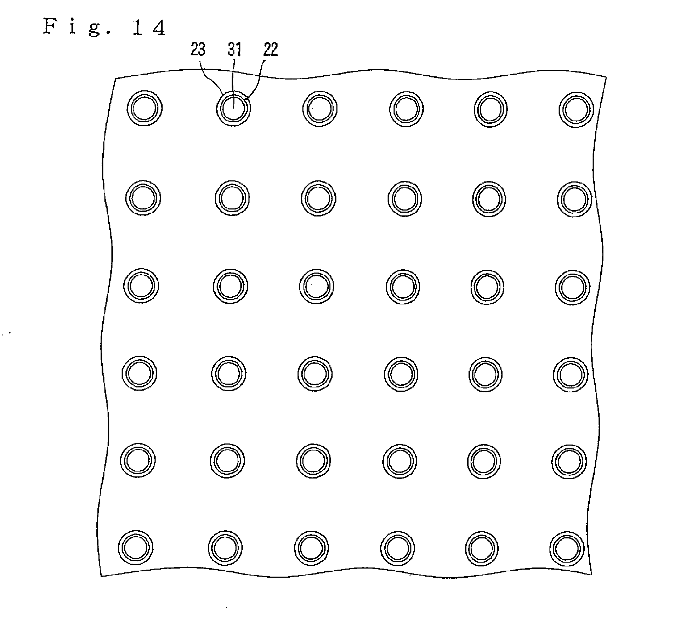

An inspection apparatus for circuit board was produced in accordance with the same specification as in Example 1 except that each of the terminal electrodes (23) in the wiring board (21) for connection of the upper-side adaptor (20) was formed so as to overlap the connecting electrode (22) when the upper-side adaptor (20) was seen through in the thickness-wise direction thereof, and the upper-side pressing pin mechanism (30) was arranged in such a manner that the tip surface (pressing surface) of each of the pressing pins (31) thereof was located on the terminal electrode (23) as illustrated in Fig. 14.

With respect to this inspection apparatus for circuit board, a connection stability test and a durability test were conducted in the same manner as in Example 1. The results of the connection stability test are shown in Table 1, while the results of the durability test are shown in Table 2.

**Table 1**

| | Proportion of NG Inspection Points (%) | | | | | | Connectable Load (k g f) |
|---|---|---|---|---|---|---|---|
| Press Load (kgf) | 1 0 | 1 2. 5 | 1 5 | 17.5 | 20 | 22.5 | |
| Example 1 | 0 | 0 | 0 | 0 | 0 | 0 | 1 0 |
| Comparative Example 1 | 1 2 | 3. 5 | 0. 8 | 0.0 3 | 0 | 0 | 1 7. 5 |

**Table 2**

| | Press Load | Proportion of NG Inspection Points (%) | | | |
|---|---|---|---|---|---|
| | (kgf) | First time | 1 0 0 0 0 times | 5 0 0 0 times | 1 0 0 0 0 times |
| Example 1 | 10 | 0 | 0 | 0 | 0 |
| | 1 7. 5 | 0 | 0 | 0 | 0 |
| | 2 2. 5 | 0 | 0 | 0 | 0. 4 |
| Comparative Example 1 | 1 0 | Unable to Measure | Unable to Measure | Unable to Measure | Unable to Measure |
| | 1 7. 5 | 0 | 0 | 0. 0 8 | 0. 4 |
| | 2 2. 5 | 0 | 0. 2 | 1. 7 | Unable to Measure |

### <Example 2>

An inspection apparatus for circuit board of the following specification was produced in accordance with the construction shown in Figs. 8 to 10.

### [Upper-side adaptor (20)]

A wiring board (21) for connection is such that a material of its base material is a glass fiber-reinforced epoxy resin, the thickness is 200 µm, it has 596 pairs of rectangular connecting electrodes (22c) each composed of a connecting electrode (22a) for current supply and a connecting electrode (22b) for voltage measurement and 1192 circular terminal electrodes (23), a minimum connecting electrode (22a) for current supply and a minimum connecting electrode (22b) for voltage measurement each have dimensions of 30 µm by 60 µm, a clearance between the connecting electrode (22a) for current supply and the connecting electrode (22b) for voltage measurement is 30 µm, a minimum pitch between the pairs of connecting electrodes (22c) is 200 µm, and a diameter of the terminal electrodes (23) is 60 µm. The terminal electrodes (23) are arranged in such a manner that two terminal electrodes (23) are located in a specific electrode region (R2) when the wiring board (21) for connection is seen through in a thickness-wise direction thereof, the terminal electrodes (23) are arranged so as not to overlap the connecting electrodes (22) (see Fig. 11), and a minimum pitch (center distance) between 2 terminal electrodes (23) arranged in the same specific electrode region (R2) is 90 µm.

A first anisotropically conductive elastomer sheet (25) is a dispersion type anisotropically conductive sheet obtained by containing nickel particles (average particle diameter: 10 µm; coating amount of gold: 4% by weight) plated with gold in a proportion of 25% in terms of volume fraction in silicone rubber and having a thickness of 100 µm. As the silicone rubber, was used a cured product of two-pack type addition type liquid silicone rubber, whose compression set was 5% at 150°C and whose tear strength was at least 25 kN/m at 23°C.

A second anisotropically conductive elastomer sheet (26) is a dispersion type anisotropically conductive sheet obtained by containing nickel particles (average particle diameter: 20 µm; coating amount of gold: 4% by weight) plated with gold in a proportion of 25% in terms of volume fraction in silicone rubber and having a thickness of 200 µm. As the silicone rubber, was used a cured product of two-pack type addition type liquid silicone rubber, whose compression set was 5% at 150°C and whose tear strength was at least 25 kN/m at 23°C.

### [Upper-side pressing pin mechanism (30)]

The total number of pressing pins (31) is 1,192, each of them is composed of brass plated with gold, the overall length [length from a proximal surface of a body part (32) to a tip surface of a projected part (33)] thereof is 6.1 mm, and the projected part (33) is provided as an inspection electrode. The specific dimensions of the respective parts in the pressing pin (31) are as follows. An outer diameter of the projected part (33) is 50 µm, a length (thickness of the inspection electrode) of the projected part (33) is 100 µm, an outer diameter of the body part (32) is 60 µm, a length of the body part (32) is 6 mm, an outer diameter of a flange part (34) is 70 µm, a thickness of the flange part (34) is 100 µm, a length [length of a proximal portion in the body part (32)] from a proximal end to a proximal-side end surface of the flange part (34) in the body part (32) is 3 mm, and a length [length of a tip portion in the body part (32)] from a tip end to a tip-side end surface of the flange part (34) in the body part (32) is 2.9 mm.

A pressing pin supporting member (35) is composed of a glass fiber-reinforced epoxy resin, a proximal-side supporting plate (36) has dimensions of 70 mm by 70 mm by 10 mm, and a tip-side supporting plate (37) has dimensions of 50 mm by 50 mm by 3 mm.

The upper-side pressing pin mechanism (30) is arranged in such a manner that two pressing pins (31) are located in a specific electrode region R2 when the upper-side pressing pin mechanism (30) and the upper-side adaptor (20) are seen through in the thickness-wise direction thereof, the tip surfaces (pressing surfaces) of the pressing pins (31) are arranged so as not to overlap the connecting electrodes (22) (see Fig. 11), and a minimum pitch (center distance) between 2 pressing pins (31) arranged in the same specific electrode region (R2) is 90 µm.

### [Lower-side adaptor (50)]

A wiring board (51) for connection is such that a material of its base material is a glass fiber-reinforced epoxy resin, the thickness is 200 µm, it has 400 pairs of rectangular connecting electrodes (52c) each composed of a connecting electrode (52a) for current supply and a connecting electrode (52b) for voltage measurement and 800 circular terminal electrodes (53), a minimum connecting electrode (52a) for current supply and a minimum connecting electrode (52b) for voltage measurement each have dimensions of 90 µm by 150 µm, a clearance between the connecting electrode (52a) for current supply and the connecting electrode (52b) for voltage measurement is 120 µm, a minimum pitch between the pairs of connecting electrodes (52c) is 1,000 µm, a diameter of the terminal electrodes (53) is 100 µm, and a pitch between the terminal electrodes (53) is 500 µm.

A first anisotropically conductive elastomer sheet (55) is a dispersion type anisotropically conductive sheet obtained by containing nickel particles (average particle diameter: 10 µm; coating amount of gold: 4% by weight) plated with gold in a proportion of 25% in terms of volume fraction in silicone rubber and having a thickness of 100 µm. As the silicone rubber, was used a cured product of two-pack type addition type liquid silicone rubber, whose compression set was 5% at 150°C and whose tear strength was at least 25 kN/m at 23°C.

A second anisotropically conductive elastomer sheet (56) is a dispersion type anisotropically conductive sheet obtained by containing nickel particles (average particle diameter: 20 µm; coating amount of gold: 4% by weight) plated with gold in a proportion of 25% in terms of volume fraction in silicone rubber and having a thickness of 200 µm. As the silicone rubber, was used a cured product of two-pack type addition type liquid silicone rubber, whose compression set was 5% at 150°C and whose tear strength was at least 25 kN/m at 23°C.

### [Lower-side pressing pin mechanism (60)]

The total number of pressing pins (61) is 800, each of them is composed of brass plated with gold, the overall length [length from a proximal surface of a body part (62) to a tip surface of a projected part (63)] thereof is 6.1 mm, and the projected part (63) is provided as an inspection electrode. The specific dimensions of the respective parts in the pressing pin (61) are as follows. An outer diameter of the projected part (63) is 50 µm, a length (thickness of the inspection electrode) of the projected part (63) is 100 µm, an outer diameter of the body part (62) is 60 µm, a length of the body part (62) is 6 mm, an outer diameter of a flange part (64) is 70 µm, a thickness of the flange part (64) is 100 µm, a length [length of a proximal portion in the body part (62)] from a proximal end to a proximal-side end surface of the flange part (64) in the body part (62) is 3 mm, a length [length of a tip portion in the body part (62)] from a tip end to a tip-side end surface of the flange part (64) in the body part (62) is 2.9 mm, and an arrangement pitch between the pressing pins (61) is 500 µm.

A pressing pin supporting member (65) is composed of a glass fiber-reinforced epoxy resin, a proximal-side supporting plate (66) has dimensions of 70 mm by 70 mm by 10 mm, and a tip-side supporting plate (67) has dimensions of 50 mm by 50 mm by 3 mm.

### [Evaluation of inspection apparatus for circuit board]

With respect to the above-described inspection apparatus for circuit board, a connection stability test and a durability test were conducted by means of a circuit board for evaluation of the following specification in accordance with the following respective methods. [Specification of circuit board for evaluation]

The overall dimensions of the circuit board for evaluation are 30 mm by 30 mm by 1 mm, semispherical one surface-side electrodes to be inspected are arranged in lattice on one surface thereof, the total number of the electrodes is 596, a diameter of a minimum one surface-side electrode to be inspected is 120 µm, a minimum pitch thereof is 200 µm, flat plate-like other surface-side electrodes to be inspected are arranged in lattice at a pitch of 1 mm on the other surface thereof, the total number of the electrodes is 400, and a diameter of the other surface-side electrode to be inspected is 0.5 mm. The projected height of the one surface-side electrodes to be inspected is about 60 µm on the average, its maximum value is about 80 µm, and its minimum value is about 40 µm. This circuit board for evaluation is referred to as "Circuit Board (W2)".

### [Connection stability test]

The inspection apparatus for circuit board was installed in an inspection section of a Step-and-Repeat Testing System for BGM-MCM ("GATS-7300", manufactured by NIDEC-READ CORPORATION), and Circuit Board (W2) was set in an inspection region of the inspection apparatus for circuit board. A pressing operation was then conducted for Circuit Board (W2) under a prescribed press load. In this state, an electric resistance value as to Circuit Board (W2) was measured by measuring an electric resistance between a connecting electrode for voltage measurement of the wiring board for connection in the upper-side adaptor and a connecting electrode for voltage measurement of the wiring board for connection in the lower-side adaptor while applying a current of 1 mA between a connecting electrode for current supply of the wiring board for connection in the upper-side adaptor and a connecting electrode for current supply of the wiring board for connection in the lower-side adaptor. The number of inspection points (hereinafter referred to as "NG inspection points") at which the electric resistance value measured reached 100 Ω or higher was then counted. After this operation of counting the NG inspection points was repeated 10 times, a proportion (hereinafter referred to as "proportion of NG inspection points") of the number of the NG inspection points to the total number of inspection points was calculated out. The step of calculating out such a proportion of NG inspection points was conducted by changing the press load stepwise in a range of 10 to 22.5 kg, thereby determining a minimum press load under which the proportion of NG inspection points was 0.01% or lower. In actual inspection of circuit boards, it is necessary that the proportion of NG inspection points is 0.01% or lower. If the proportion of NG inspection points exceeds 0.01%, there is a possibility that a nondefective circuit board to be inspected may be judged to be a defective. It is hence difficult to conduct electrical inspection as to circuit board with high reliability.

The press load determined in such a manner is referred to as "connectable load". The smaller connectable load value indicates that the connection stability is higher.

The results of the above-described connection stability test are shown in Table 3.

### [Durability test]

The inspection apparatus for circuit board was installed in an inspection section of a Step-Repeat Testing System for BGM-MCM ("GATS-7300", manufactured by NIDEC-READ CORPORATION), and Circuit Board (W2) was set in an inspection region of the inspection apparatus for circuit board. After a pressing operation was then conducted prescribed times for Circuit Board (W2) under a load of 10 kgf, an electric resistance value as to Circuit Board (W2) was measured under conditions of 10 kgf load by measuring an electric resistance between a connecting electrode for voltage measurement of the wiring board for connection in the upper-side adaptor and a connecting electrode for voltage measurement of the wiring board for connection in the lower-side adaptor while applying a current of 1 mA between a connecting electrode for current supply of the wiring board for connection in the upper-side adaptor and a connecting electrode for current supply of the wiring board for connection in the lower-side adaptor. The number of inspection points (NG inspection points) at which the electric resistance value measured reached 100 Ω or higher was counted to calculate out a proportion (proportion of NG inspection points) of the number of the NG inspection points to the total number of inspection points. The process of calculating out such a proportion of NG inspection points was conducted repeatedly 10,000 times.

A proportion of NG inspection points was determined in the same manner as described above except that the anisotropically conductive elastomer sheets in the inspection apparatus were replaced by new ones, and the press load in the pressing operation and electric resistance-measuring operation were changed to 17.5 kg and 22.5 kgf.

The results of the above-described durability test are shown in Table 4.

### <Comparative Example 2>

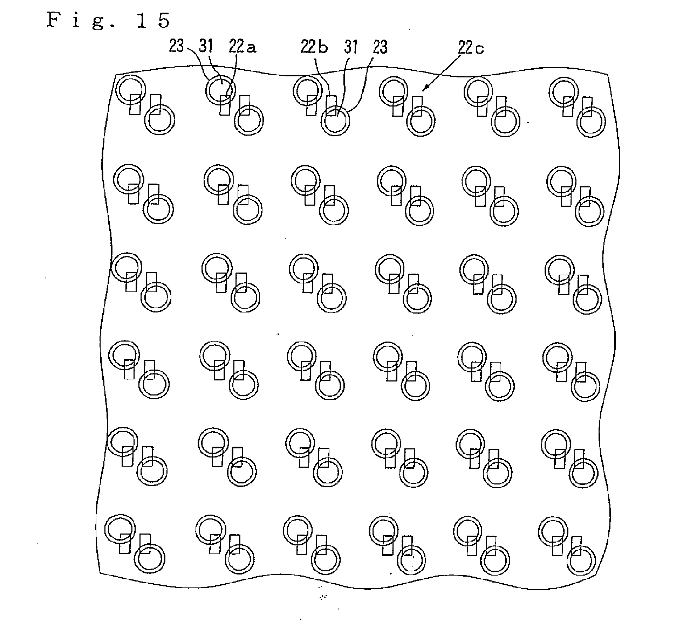

An inspection apparatus for circuit board was produced under the same conditions as in Example 2 except that each of the terminal electrodes (23) in the wiring board (21) for connection of the upper-side adaptor (20) was formed so as to overlap any of the connecting electrode (22a) for current supply and the connecting electrode (22b) for voltage measurement when the upper-side adaptor (20) was seen through in the thickness-wise direction thereof, and the upper-side pressing pin mechanism (30) was arranged in such a manner that the tip surface (pressing surface) of each of the pressing pins (31) thereof was located on the terminal electrode (23) as illustrated in Fig. 15.

With respect to this inspection apparatus for circuit board, a connection stability test and a durability test were conducted in the same manner as in Example 2. The results of the connection stability test are shown in Table 3, while the results of the durability test are shown in Table 4.

**Table 3**

| | Proportion of NG Inspection Points (%) | | | | | | Connectable Load (k g f) |
|---|---|---|---|---|---|---|---|
| Press Load (k g f) | 1 0 | 1 2. 5 | 1 5 | 1 7. 5 | 2 0 | 2 2. 5 | |
| Example 2 | 0 | 0 | 0 | 0 | 0 | 0 | 1 0 |
| Comparative Example 2 | 7. 2 | 2. 8 | 1. 3 | 0. 0 5 | 0 | 0 | 2 0 |

**Table 4**

| | Press Load | Proportion of NG Inspection Points (%) | | | |
|---|---|---|---|---|---|
| | (kgf) | First time | 1 0 0 0 times | 5 0 0 0 times | 1 0 0 0 0 times |
| Example 2 | 1 0 | 0 | 0 | 0 | 0 |
| | 1 7. 5 | 0 | 0 | 0 | 0 |
| | 2 2. 5 | 0 | 0 | 0. 0 6 | 3. 2 |
| Comparative Example 2 | 1 0 | Unable to Measure | Unable to Measure | Unable to Measure | Unable to Measure |
| | 1 7. 5 | Unable to Measure | Unable to Measure | Unable to Measure | Unable to Measure |
| | 2 2. 5 | 0 | 0. 0 5 | 3. 6 | Unable to Measure |

As apparent from the results shown in Tables 1 to 4, it was confirmed that according to the inspection apparatus for circuit board of Example 1 and Example 2, the first anisotropically conductive elastomer sheet in the upper-side adaptor is prevented from causing trouble prematurely, and so long service life is achieved, and moreover stable electrical connection is attained to all electrodes to be inspected.

## Claims

1. An inspection apparatus for circuit board for inspecting the electrical properties of a circuit board having a plurality of electrodes to be inspected arranged in lattice, which comprises
an adaptor having a wiring board for connection, on the front surface of which a plurality of connecting electrodes have been formed in accordance with a pattern corresponding to a pattern of the electrodes to be inspected of the circuit board, which is an object of inspection, and an anisotropically conductive elastomer sheet arranged on the front surface of the wiring board for connection, and a pressing pin mechanism arranged on the back surface side of the wiring board for connection in the adaptor and having a great number of pressing pins for pressing the adaptor,
wherein the great number of the pressing pins in the pressing pin mechanism are arranged in such a manner that at least one pressing pin is located within a rectangular region partitioned by linking central points of adjacent 4 connecting electrodes in the wiring board for connection when the pressing pin mechanism and the adaptor are seen through in a thickness-wise direction thereof.

2. The inspection apparatus for circuit board according to claim 1, wherein on the back surface of the wiring board for connection in the adaptor, a terminal electrode electrically connected to the connecting electrode is arranged at pressing positions by all the pressing pins in the pressing pin mechanism or a pressing position by at least one specified pressing pin selected from among all the pressing pins, and an inspection electrode is formed on the tip of the pressing pin pressing the pressing position at which the terminal electrode is arranged.

3. An inspection apparatus for circuit board for inspecting the electrical properties of a circuit board having a plurality of electrodes to be inspected arranged in lattice, which comprises
an adaptor having a wiring board for connection, on the front surface of which plural pairs of connecting electrodes each composed of a connecting electrode for current supply and a connecting electrode for voltage measurement have been formed in accordance with a pattern corresponding to a pattern of the electrodes to be inspected of the circuit board, which is an object of inspection, and an anisotropically conductive elastomer sheet arranged on the front surface of the wiring board for connection, and a pressing pin mechanism arranged on the back surface side of the wiring board for connection in the adaptor and having a great number of pressing pins for pressing the adaptor, wherein the great number of the pressing pins in the pressing pin mechanism are arranged in such a manner that at least one pressing pin is located within a rectangular region partitioned by linking central points of adjacent 4 pairs of connecting electrodes in the wiring board for connection when the pressing pin mechanism and the adaptor are seen through in a thickness-wise direction thereof.

4. The inspection apparatus for circuit board according to claim 3, wherein on the back surface of the wiring board for connection in the adaptor, terminal electrodes electrically connected to any ones of the connecting electrodes for current supply and the connecting electrodes for voltage measurement are arranged at pressing positions by all the pressing pins in the pressing pin mechanism or a pressing position by at least one specified pressing pin selected from among all the pressing pins, and inspection electrodes are formed on the tips of the pressing pins pressing the pressing positions at which the terminal electrodes are arranged.

5. The inspection apparatus for circuit board according to any one of claims 1 to 4, wherein the circuit board, which is the object of inspection, has projected electrodes to be inspected.

6. The inspection apparatus for circuit board according to claim 5, wherein the wiring board for connection in the adaptor is capable to be curved in such a manner that when the adaptor is held under pressure by the respective pressing pins in the pressing pin mechanism and the respective electrodes to be inspected of the circuit board, which is the object of inspection, portions being applied with the pressing force by the respective pressing pins and the respective electrodes to be inspected are shifted in pressing directions.

7. The inspection apparatus for circuit board according to any one of claims 1 to 6, wherein the anisotropically conductive elastomer sheet arranged on the front surface of the wiring board for connection is obtained by containing a great number of conductive particles exhibiting magnetism in an elastic polymeric substance, and the conductive particles are oriented so as to align in a thickness-wise direction of the sheet, thereby forming a plurality of chains by the conductive particles.

8. The inspection apparatus for circuit board according to claim 7, wherein the anisotropically conductive elastomer sheet arranged on the front surface of the wiring board for connection is such that chains by the conductive particles are formed in a state dispersed in a plane direction.

9. The inspection apparatus for circuit board according to claim 8, wherein the anisotropically conductive elastomer sheet arranged on the front surface of the wiring board for connection has a thickness of 30 to 300 µm.

10. The inspection apparatus for circuit board according to any one of claims 1 to 9, wherein the adaptor has an anisotropically conductive elastomer sheet arranged on the back surface of the wiring board for connection.

11. An inspection process for circuit board for inspecting the electrical properties of a circuit board having a plurality of projected electrodes to be inspected arranged in lattice, which comprises
using an adaptor having a wiring board for connection and an anisotropically conductive elastomer sheet arranged on a front surface of the wiring board for connection, and a pressing pin mechanism, on which a great number of pressing pins for pressing the adaptor have been arranged, and comprises the steps of
arranging the adaptor on the circuit board, which is an object of inspection, so as to bring the anisotropically conductive elastomer sheet thereof into contact with the circuit board to attain a state that the pressing pin mechanism has been arranged in such a manner that at least one pressing pin is located within a rectangular region partitioned by linking central points of adjacent 4 electrodes to be inspected in the circuit board when the adaptor and the circuit board are seen through in a thickness-wise direction thereof, and
pressing the adaptor by the respective pressing pins of the pressing pin mechanism to bring the anisotropically conductive elastomer sheet in the adaptor into contact under pressure with the electrodes to be inspected of the circuit board, thereby attaining an inspectable state that each of the electrodes to be inspected of the circuit board have been electrically connected to a tester,
wherein the wiring board for connection in the adaptor is capable to be curved in such a manner that portions being applied with the pressing force by the respective pressing pins and the respective electrodes to be inspected are shifted in the pressing direction.

12. A wiring board for connection for intervening between a circuit board having a plurality of electrodes to be inspected arranged in lattice and a tester to inspect the electrical properties of the circuit board, which comprises
a plurality of connecting electrodes formed in accordance with a pattern corresponding to a pattern of the electrodes to be inspected of the circuit board, which is an object of inspection, on a front surface thereof and a plurality of terminal electrodes electrically connected to the connecting electrodes on a back surface thereof,
wherein the plurality of the terminal electrodes are arranged in such a manner that at least one terminal electrode is located within a rectangular region partitioned by linking central points of adjacent 4 connecting electrodes when the wiring board for connection is seen through in a thickness-wise direction thereof.

13. A wiring board for connection for intervening between a circuit board having a plurality of electrodes to be inspected arranged in lattice and a tester to inspect the electrical properties of the circuit board, which comprises
plural pairs of connecting electrodes each composed of a connecting electrode for current supply and a connecting electrode for voltage measurement and formed in accordance with a pattern corresponding to a pattern of the electrodes to be inspected of the circuit board, which is an object of inspection, on a front surface thereof and a plurality of terminal electrodes electrically connected to any ones of the connecting electrodes for current supply and the connecting electrodes for voltage measurement on a back surface thereof,
wherein the plurality of the terminal electrodes are arranged in such a manner that at least one terminal electrode is located within a rectangular region partitioned by linking central points of adjacent 4 pairs of connecting electrodes when the wiring board for connection is seen through in a thickness-wise direction thereof.
